# EUROPEAN PATENT APPLICATION

(11) **EP 4 451 331 A1**
(43) Date of publication of application: **23.10.2024**
(21) Application number: 24151217.7
(22) Date of filing: 10.01.2024
(51) Int. Cl.: H01L 27/02, H01L 27/06, H01L 27/092, H10B 10/00, H01L 23/528

(54) **SEMICONDUCTOR MEMORY DEVICE AND METHOD OF FABRICATING THE SAME**

(30) Priority: 18.04.2023 KR 20230050635
(71) Applicant: Samsung Electronics Co., Ltd., Suwon-si, Gyeonggi-do 16677 (KR)
(72) Inventor: HWANG, Inchan, 16677 Suwon-si (KR); CHO, Kyung Hee, 16677 Suwon-si (KR); LEE, Seunghun, 16677 Suwon-si (KR)
(74) Representative: Marks & Clerk LLP

(57) **Abstract**

A semiconductor memory device comprising a substrate having first and second surfaces opposite to each other, a lower active region on the first surface and including a first lower gate electrode and a first lower active contact, an upper active region on the lower active region and including a first upper gate electrode and a first upper active contact that vertically overlap at least a part of the first lower active contact, a first connection structure vertically connecting the first upper active contact to the first lower active contact, a first metal layer on the first surface, and a backside metal layer on the second surface. The first upper gate electrode and the first lower gate electrode are connected and form a first gate electrode. The first metal layer includes a first node line electrically connecting the first gate electrode to the first upper active contact.

## Description

### BACKGROUND

Various example embodiments relate to a semiconductor memory device and/or a method of fabricating the same, and more particularly, to a semiconductor memory device including a static random access memory (SRAM) cell and/or a method of fabricating the same.

A semiconductor device attracts attention in the electronic industry because of its properties such as compactness, multi-functionality, and/or low manufacturing cost. Semiconductor devices may encompass one or more of semiconductor memory devices storing logic data, semiconductor logic devices processing operations of logic data, and hybrid semiconductor devices having both memory and logic elements. Semiconductor devices have been increasingly required or used for high integration with the advanced development of the electronic industry. For example, semiconductor devices have been increasingly requested or expected for high reliability, high speed, and/or multi-functionality. Semiconductor devices are gradually becoming more complicated and more integrated to meet these requested characteristics.

### SUMMARY

Various example embodiments of inventive concepts provide a semiconductor memory device having improved electrical properties and/or increased integration.

Alternatively or additionally, some example embodiments of inventive concepts provide a method of fabricating a semiconductor memory device having improved electrical properties and/or increased integration.

According to various example embodiments, a semiconductor memory device may comprise: a substrate that has a first surface and a second surface opposite to the first surface; a lower active region on the first surface, wherein the lower active region includes a first lower gate electrode and a first lower active contact spaced apart from the first lower gate electrode; an upper active region on the lower active region, wherein the upper active region includes a first upper gate electrode and a first upper active contact spaced apart from the first upper gate electrode, wherein the first upper active contact vertically overlaps at least part of the first lower active contact; a first connection structure that vertically connects the first upper active contact to the first lower active contact; a first metal layer on the first surface; and a backside metal layer on the second surface. The first upper gate electrode and the first lower gate electrode may be connected to constitute or to form a first gate electrode. The first metal layer may include a first node line that electrically connects the first gate electrode to the first upper active contact.

Alternatively or additionally according to various example embodiments, a semiconductor memory device may comprise an SRAM cell on a substrate. The SRAM cell may include: a backside metal layer; a lower active region on the backside metal layer; an upper active region on the lower active region; and a first metal layer on the upper active region. The lower active region may include four first FETS arranged in a 1x4 arrangement. The upper active region may include four second FETS arranged in a 1x4 arrangement. The first FETS may include a first pull-up transistor and a second pull-up transistor. The second FETS may include a first pass-gate transistor, a second pass-gate transistor, a first pull-down transistor, and a second pull-down transistor. The first pull-down transistor may be on the first pull-up transistor. The second pull-down transistor may be on the second pull-up transistor.

Alternatively or additionally according to various example embodiments, a semiconductor memory device may comprise: a substrate that has a first surface and a second surface opposite to the first surface; a lower active region on the first surface, wherein the lower active region includes a lower channel pattern and a lower source/drain pattern; an upper active region on the lower active region, wherein the upper active region includes an upper channel pattern and an upper source/drain pattern; a lower gate electrode on the lower channel pattern; an upper gate electrode on the upper channel pattern; an interlayer dielectric layer on the upper gate electrode and the upper source/drain pattern; a lower active contact that penetrates the substrate and is electrically connected to the lower source/drain pattern; an upper active contact that penetrates the interlayer dielectric layer and is electrically connected to the upper source/drain pattern, wherein the upper active contact includes a first portion that vertically overlaps at least a part of the lower active contact and at least a part of the second portion other than the first portion; a backside metal layer on the second surface of the substrate, wherein the backside metal layer includes a ground line and a power line; a first metal layer on the interlayer dielectric layer; a first lower via that electrically connects the ground line to the lower active contact; and a second lower via that electrically connects the power line to the second portion of the upper active contact.

At least some of the above and other features of the invention are set out in the claims.

### BRIEF DESCRIPTION OF DRAWINGS

FIG. 1 illustrates an equivalent circuit diagram showing a static random access memory (SRAM) cell according to various example embodiments.
FIG. 2A illustrates a plan view of a first surface of a substrate, showing a semiconductor memory device according to various example embodiments.
FIG. 2B illustrates a plan view of a second surface of a substrate, showing a semiconductor memory device according to various example embodiments.
FIG. 3A illustrates a cross-sectional view taken along line A-A' of FIGS. 2A and 2B.
FIG. 3B illustrates a cross-sectional view taken along line B-B' of FIGS. 2A and 2B.
FIG. 3C illustrates a cross-sectional view taken along line C-C' of FIGS. 2A and 2B.
FIG. 3D illustrates a cross-sectional view taken along line D-D' of FIGS. 2A and 2B.
FIG. 4 illustrates a simplified perspective view showing layers included in a bit cell according to various example embodiments.
FIGS. 5A to 9C illustrate cross-sectional views showing a method of fabricating a semiconductor memory device according to various example embodiments.
FIG. 10A illustrates a plan view of a first surface of a substrate, showing a semiconductor memory device according to various example embodiments.
FIG. 10B illustrates a plan view of a second surface of a substrate, showing a semiconductor memory device according to various example embodiments.
FIG. 11A illustrates a cross-sectional view taken along line A-A' of FIGS. 10A and 10B.
FIG. 11B illustrates a cross-sectional view taken along line B-B' of FIGS. 10A and 10B.
FIG. 11C illustrates a cross-sectional view taken along line C-C' of FIGS. 10A and 10B.
FIG. 11D illustrates a cross-sectional view taken along line D-D' of FIGS. 10A and 10B.
FIG. 12 illustrates a plan view of a first surface of a substrate, showing a semiconductor memory device according to various example embodiments.
FIG. 13A illustrates a cross-sectional view taken along line A-A' of FIG. 12.
FIG. 13B illustrates a cross-sectional view taken along line B-B' of FIG. 12.

### DETAILED DESCRIPTION OF VARIOUS EXAMPLE EMBODIMENTS

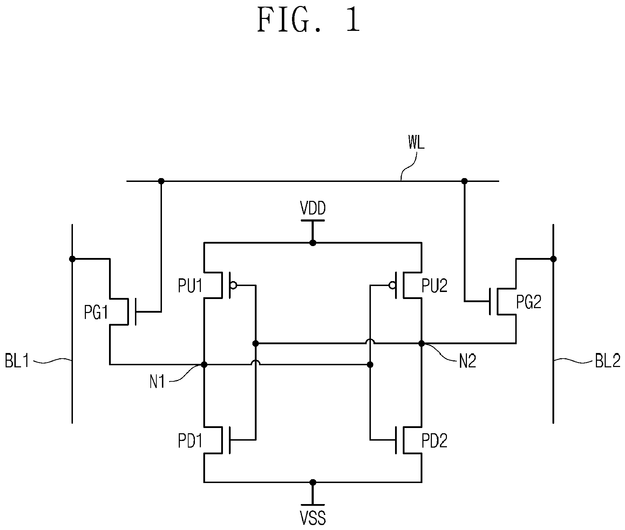

FIG. 1 illustrates an equivalent circuit diagram showing a static random access memory (SRAM) cell according to various example embodiments of inventive concepts. Referring to FIG. 1, a static random access memory (SRAM) cell according to various example embodiments of inventive concepts may include a first pull-up transistor PU1, a first pull-down transistor PD1, a second pull-up transistor PU2, a second pull-down transistor PD2, a first pass-gate transistor PG1, and a second pass-gate transistor PG2. The first and second pull-up transistors PU1 and PU2 may be PMOS transistors. The first and second pull-down transistors PD1 and PD2 and the first and second pass-gate transistors PG1 and PG2 may be NMOS transistors; example embodiments are not limited thereto. Furthermore, the SRAM cell may be a six-transistor (6T) SRAM cell; however, example embodiments are not limited thereto. For example, the SRAM cell may be a four-transistor (4T) or an eight-transistor (8T) SRAM cell.

A first node N1 may be connected to a first source/drain of the first pull-up transistor PU1 and a first source/drain of the first pull-down transistor PD1. A first line, e.g., a power line VDD may be connected to a second source/drain of the first pull-up transistor PU1, and a second line, e.g., a ground line VSS may be connected to a second source/drain of the first pull-down transistor PD1. The first pull-up transistor PU1 may have a gate electrically connected to that of the first pull-down transistor PD1. The first pull-up transistor PU1 and the first pull-down transistor PD1 may constitute or correspond to, or be, or be included in, a first inverter. The first inverter may have an input terminal that corresponds to the connected gates of the first pull-up and pull-down transistors PU1 and PD1, and may also have an output terminal that corresponds to the first node N1.

A second node N2 may be connected to a first source/drain of the second pull-up transistor PU2 and a first source/drain of the second pull-down transistor PD2. The power line VDD may be connected to a second source/drain of the second pull-up transistor PU2, and the ground line VSS may be connected to a second source/drain of the second pull-down transistor PD2. The second pull-up and pull-down transistors PU2 and PD2 may have their gates that are electrically connected to each other. The second pull-up transistor PU2 and the second pull-down transistor PD2 may thus constitute or correspond to, or be, or be included in a second inverter. The second inverter may have an input terminal that corresponds to the connected gates of the second pull-up and pull-down transistors PU2 and PD2, and may also have an output terminal that corresponds to the second node N2.

Various properties such as various electrical and/or geometrical properties of the first pull-up and the pull-down transistors PU1 and PD1, the second pull-up and the second pull-down transistors PU2 and PD2, and the first and second pass-gate transistors PG1 and PG2 may be the same as, or different from, one another. For example, one or more of the threshold voltages and/or the drive currents of the first pass-gate transistor PG1, the first pull-up transistor PU1, and the first pull-down transistor PD1 may be the same as, or different than, the respective second pass-gate transistor PG2, the second pull-up transistor PU2, and the second pull-down transistor PD2. Example embodiments are not limited thereto.

The first and second inverters may be connected to each other to constitute or correspond to a latch structure or a pair of cross-coupled inverters. In this configuration, the gates of the first pull-up and pull-down transistors PU1 and PD1 may be electrically connected to the second node N2, and the gates of the second pull-up and pull-down transistors PU2 and PD2 may be electrically connected to the first node N1. The first pass-gate transistor PG1 may have a first source/drain connected to the first node N1 and a second source/drain connected to a first column or first bit line BL1. The second pass-gate transistor PG2 may have a first source/drain connected to the second node N2 and a second source/drain connected to a second column or second bit line BL2. The first and second pass-gate transistors PG1 and PG2 may have their gates electrically connected to a row or a word line WL. The configuration mentioned above may achieve the SRAM cell according to various example embodiments of inventive concepts.

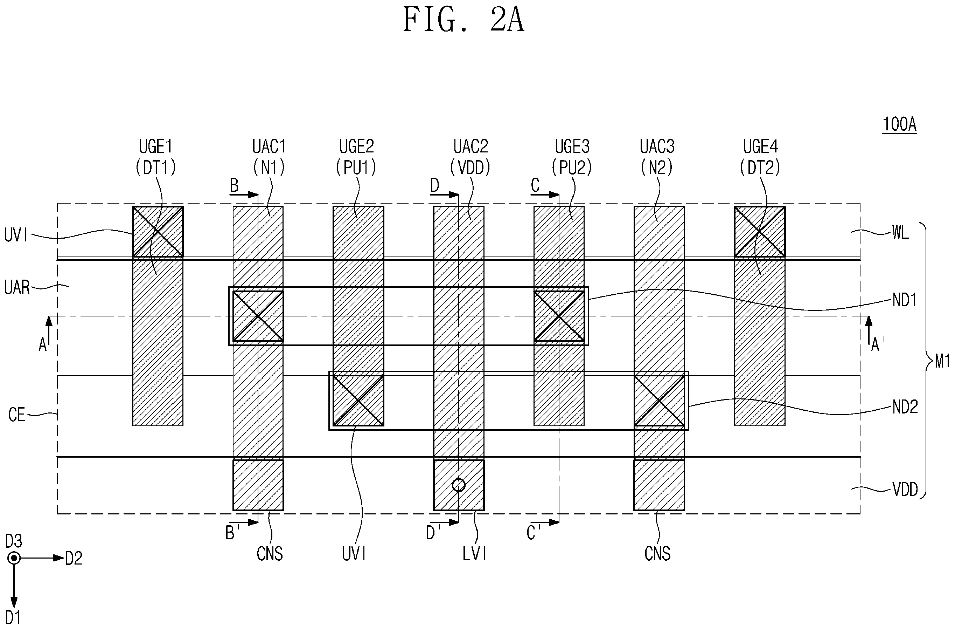

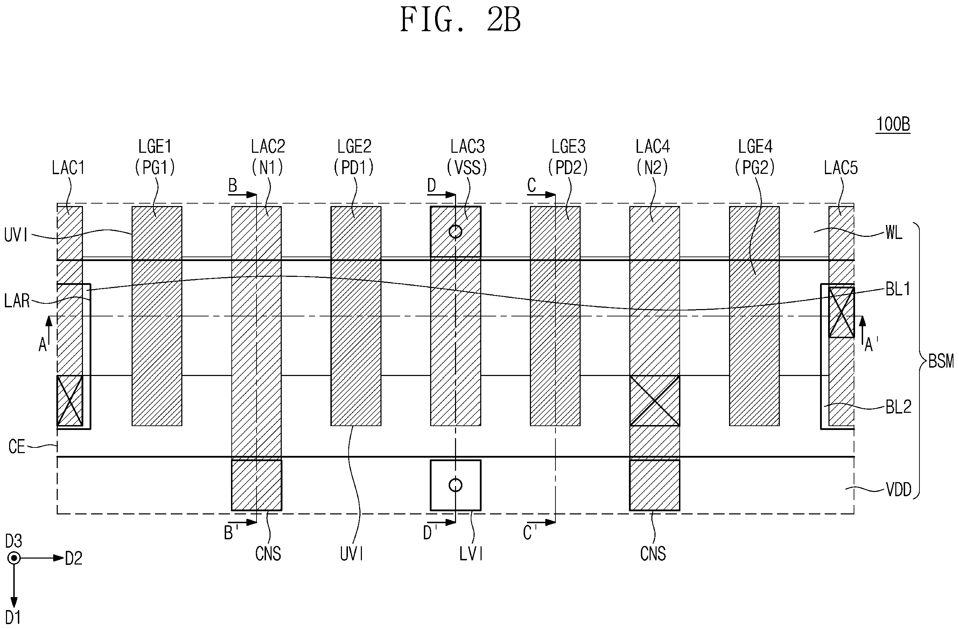

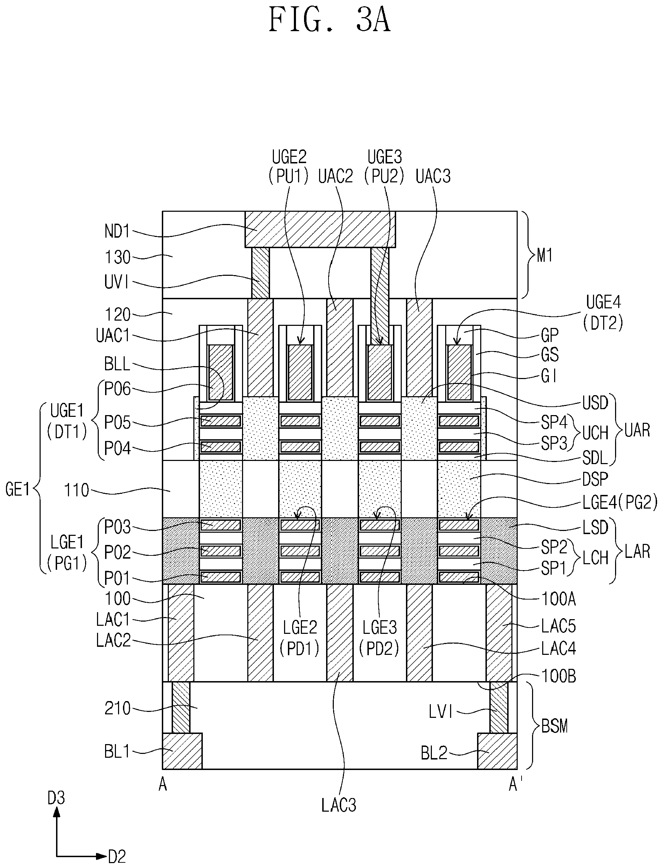

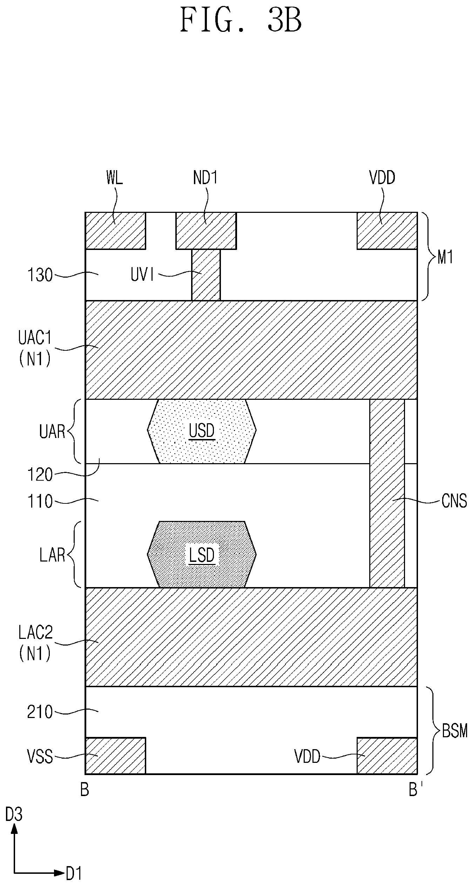

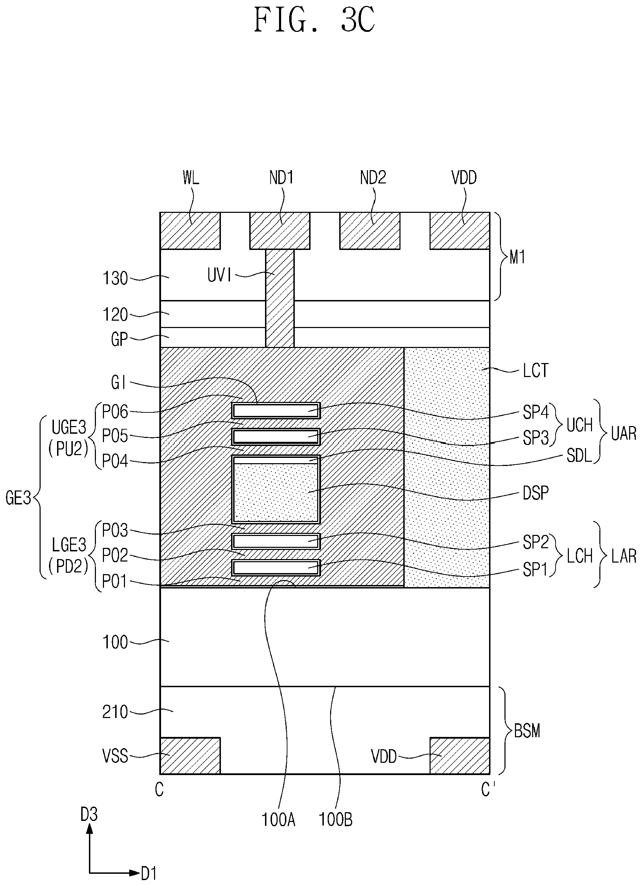

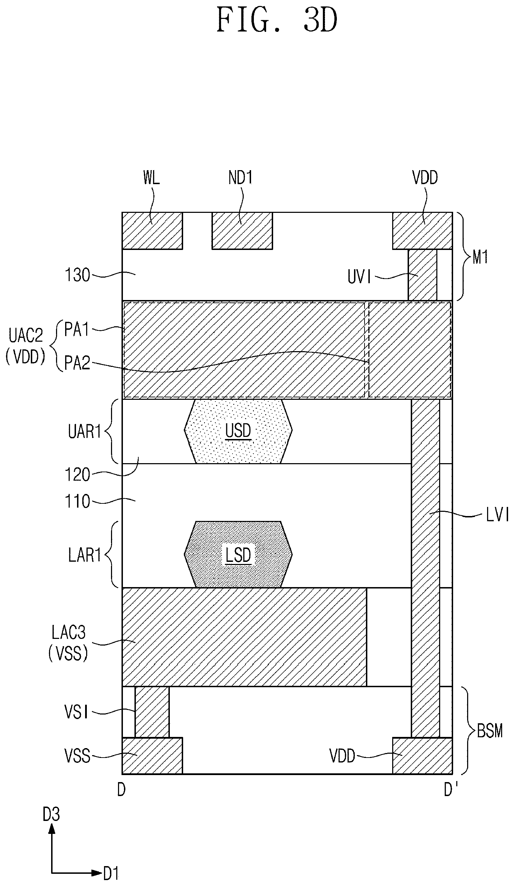

FIG. 2A illustrates a plan view of a first surface of a substrate, showing a semiconductor memory device according to various example embodiments of inventive concepts. FIG. 2B illustrates a plan view of a second surface of a substrate, showing a semiconductor memory device according to various example embodiments of inventive concepts. FIG. 3A illustrates a cross-sectional view taken along line A-A' of FIGS. 2A and 2B. FIG. 3B illustrates a cross-sectional view taken along line B-B' of FIGS. 2A and 2B. FIG. 3C illustrates a cross-sectional view taken along line C-C' of FIGS. 2A and 2B. FIG. 3D illustrates a cross-sectional view taken along line D-D' of FIGS. 2A and 2B. The present embodiment will discuss a detailed example of an SRA cell according to a circuit diagram depicted in FIG. 1. Directions D1, D2 and D3 are shown and discussed. It will be understood that these, as well as terms such as "upper", "higher" and "lower", represent example directions relative to a semiconductor device, and do not imply any particular orientation of such a device.

Referring to FIGS. 1, 2A, 2B, and 3A to 3D, a substrate 100 may be provided which includes a first surface 100A and a second surface 100B. The first surface 100A may be a front surface of the substrate 100, and the second surface 100B may be a rear surface of the substrate 100. In some example embodiments, the substrate 100 may be or may include, or be included in, a dielectric substrate including a silicon-based dielectric material. In some example embodiments, the substrate 100 may be or may include, or be included in a semiconductor substrate including silicon, germanium, and silicon-germanium. In some example embodiments, the substrate 100 may be a wafer such as a 200mm diameter wafer or a 300mm diameter wafer; alternatively the substrate 100 may be a diced chip. Example embodiments are not limited thereto.

The substrate 100 may be provided on its first surface 100A with a lower active region LAR and an upper active region UAR that are sequentially stacked. Various field effect transistors (FETS) may be included on the substrate 100. According to various example embodiments of inventive concepts, the lower active region LAR may be or may include, or be included in an NMOSFET region, and the upper active region UAR may be or may include, or be included in a PMOSFET region. The lower active region LAR may be provided on a bottom tier of a front-end-of-line (FEOL) layer, and the upper active region UAR may be provided on a top tier of the front-end-of-line (FEOL) layer. NMOS and PMOS transistors of the lower and upper active regions LAR and UAR may be vertically stacked to constitute or be included in a three-dimensionally stacked transistor.

When viewed in plan, the lower active region LAR may extend in a second direction D2. The lower active region LAR may include lower channel patterns LCH and lower source/drain patterns LSD. The lower channel pattern LCH may be interposed between a pair of lower source/drain patterns LSD. The lower channel pattern LCH may connect the pair of lower source/drain patterns LSD to each other.

The lower channel pattern LCH may include a first semiconductor pattern SP1 and a second semiconductor pattern SP2 that are stacked and spaced apart from each other. Each of the first and second semiconductor patterns SP1 and SP2 may include one or more of silicon (Si), germanium (Ge), or silicon-germanium (SiGe). For example, each of the first and second semiconductor patterns SP1 and SP2 may include crystalline silicon such as single-crystal silicon.

The lower source/drain pattern LSD may be an epitaxial pattern, e.g., an epitaxial pattern formed by a selective epitaxial growth (SEG) process. For example, a top surface of the lower source/drain pattern LSD may be higher than that of or above that of the second semiconductor pattern SP2 of the lower channel pattern LCH.

The lower source/drain pattern LSD may be doped with impurities to have a first conductivity type. For example, the first conductivity type may be an n-type. The lower source/drain pattern LSD may include one or more of silicon (Si) and silicon-germanium (SiGe).

In some example embodiments, the lower source/drain pattern LSD may be doped with impurities of both a first conductivity type and a second conductivity type but a concentration of impurities of the first conductivity type included in the lower source/drain pattern LSD may be much greater than a concentration of impurities of the second conductivity type included in the lower source/drain pattern LSD.

A lower active contact LAC may be provided on the lower source/drain pattern LSD. The lower active contact LAC may be electrically connected to the lower source/drain pattern LSD. In some example embodiments, the lower active contact LAC may be provided below the lower source/drain pattern LSD. When viewed in plan, the lower active contact LAC may have a bar shape that extends in a first direction D 1 (see FIG. 2B).

In some example embodiments, the lower active contact LAC may include one or more metals, for example one or more of from copper (Cu), aluminum (Al), ruthenium (Ru), cobalt (Co), tungsten (W), and molybdenum (Mo). The lower active contact LAC may be buried in the substrate 100.

A second interlayer dielectric layer 120 and the upper active region UAR may be provided on the first interlayer dielectric layer 110. The upper active region UAR may include upper channel patterns UCH and upper source/drain patterns USD. The upper channel patterns UCH may correspondingly fully or at least partly vertically overlap the lower channel patterns LCH. The upper source/drain patterns USD may correspondingly fully or at least partly vertically overlap the lower source/drain patterns LSD. The upper channel pattern UCH may be interposed between a pair of the upper source/drain patterns USD. The upper channel pattern UCH may connect the pair of upper source/drain patterns USD to each other.

The upper channel pattern UCH may include a third semiconductor pattern SP3 and a fourth semiconductor pattern SP4 that are stacked and spaced apart from each other. The third and fourth semiconductor patterns SP3 and SP4 of the upper channel pattern UCH may include the same semiconductor material as that of the first and second semiconductor patterns SP1 and SP2 of the lower channel pattern LCH.

At least one dummy channel pattern DSP may be interposed between the lower channel pattern LCH and the upper channel pattern UCH that overlies the lower channel pattern LCH. A seed layer SDL may be interposed between the dummy channel pattern DSP and the upper channel pattern UCH.

The dummy channel pattern DSP may be spaced apart from the lower and upper source/drain patterns LSD and USD. For example, the dummy channel pattern DSP may not be connected to any source/drain pattern. The dummy channel pattern DSP may include a semiconductor material such as silicon (Si), germanium (Ge), or silicon-germanium (SiGe), or a silicon-based dielectric material such as silicon oxide or silicon nitride. In some example embodiments, the dummy channel pattern DSP may include a silicon-based dielectric material.

The upper source/drain patterns USD may be provided on a top surface of the first interlayer dielectric layer 110. The upper source/drain pattern USD may be an epitaxial pattern formed by a selective epitaxial growth (SEG) process. For example, a top surface of the upper source/drain pattern USD may be higher than that of the fourth semiconductor pattern SP4 of the upper channel pattern UCH.

The upper source/drain patterns USD may be doped with impurities to have a second conductivity type. The second conductivity type may be a p-type. The upper source/drain patterns USD may include one or more of silicon-germanium (SiGe) and silicon (Si).

In some example embodiments, the upper source/drain pattern USD may be doped with impurities of both a first conductivity type and a second conductivity type but a concentration of impurities of the first conductivity type included in the upper source/drain pattern USD may be much lower than a concentration of impurities of the second conductivity type included in the upper source/drain pattern USD. In such example the net effect may be that the upper source/drain pattern has an overall conductivity of the second type, despite the presence of impurities of the first conductivity type.

The second interlayer dielectric layer 120 may cover, e.g. fully or at least partially cover, the upper source/drain patterns USD. A top surface of the second interlayer dielectric layer 120 may be coplanar with those of upper active contacts UAC which will be discussed below.

An upper active contact UAC may be provided on the upper source/drain pattern USD. The upper active contact UAC may be electrically connected to the upper source/drain pattern USD. In some example embodiments, the upper active contact UAC may be provided above the upper source/drain pattern USD. When viewed in plan, the upper active contact UAC may have a bar shape that extends in the first direction D1 (see FIG. 2A).

In some example embodiments, the upper active contact UAC may include one or more metals, for example one or more of copper (Cu), aluminum (Al), ruthenium (Ru), cobalt (Co), tungsten (W), and molybdenum (Mo). The upper active contact UAC may be provided in the second interlayer dielectric layer 120.

Lower gate electrodes LGE may be correspondingly provided on the lower channel patterns LCH. Upper gate electrodes UGE may be correspondingly provided on the upper channel patterns UCH. The lower gate electrode LGE may be provided in a bottom tier, or the lower active region LAR. The upper gate electrode UGE may be provided in a top tier, or the upper active region UAR. The upper gate electrode UGE may vertically overlap the lower gate electrode LGE that underlies the upper gate electrode UGE. When viewed in plan, the lower and upper gate electrodes LGE and UGE that overlap each other may each have a bar shape that extends in the first direction D1.

In some example embodiments, the upper gate electrode UGE and the lower gate electrode LGE may be connected to constitute one gate electrode GE. For example, referring to FIG. 3C, a third upper gate electrode UGE3 and a third lower gate electrode LGE3 may be connected to constitute one third gate electrode GE3. The third gate electrode GE3 may vertically extend from a location below the first semiconductor pattern SP1 to a location above the fourth semiconductor pattern SP4.

The lower gate electrode LGE may be provided on a top surface, a bottom surface, and opposite sidewalls of each of the first and second semiconductor patterns SP1 and SP2. The upper gate electrode UGE may be provided on a top surface, a bottom surface, and opposite sidewalls of each of the third and fourth semiconductor patterns SP3 and SP4. For example, a transistor according various example embodiments may be or may include a three-dimensional field effect transistor (e.g., MBCFET^{™} and/or GAAFET) in which a gate electrode three-dimensionally surrounds a channel.

The lower gate electrode LGE may include a first portion PO1 interposed between the substrate 100 and the first semiconductor pattern SP1, a second portion PO2 interposed between the first semiconductor pattern SP1 and the second semiconductor pattern SP2, and a third portion PO3 interposed between the second semiconductor pattern SP2 and the dummy channel pattern DSP.

The upper gate electrode UGE may include a fourth portion PO4 interposed between the dummy channel pattern DSP (or the seed layer SDL) and the third semiconductor pattern SP3, a fifth portion PO5 interposed between the third semiconductor pattern SP3 and the fourth semiconductor pattern SP4, and a sixth portion PO6 on the fourth semiconductor pattern SP4.

A pair of gate spacers GS may be disposed on opposite sidewalls of the upper gate electrode UGE. The gate spacers GS may extend in the first direction D1 along the upper gate electrode UGE. The gate spacers GS may have their top surfaces higher than that of the upper gate electrode UGE. The top surfaces of the gate spacers GS may be coplanar with that of the second interlayer dielectric layer 120. The gate spacers GS may include at least one of SiCN, SiCON, and SiN. Alternatively, the gate spacers GS may each include a multiple layer formed of at least two of SiCN, SiCON, and SiN.

A gate capping pattern GP may be provided on the top surface of the upper gate electrode UGE. The gate capping pattern GP may extend in the first direction D 1 along the upper gate electrode UGE. For example, the gate capping pattern GP may include at least one of SiON, SiCN, SiCON, and SiN.

A gate dielectric layer GI may be interposed between the lower gate electrode LGE and each of the first and second semiconductor patterns SP 1 and SP2. A gate dielectric layer GI may be interposed between the upper gate electrode UGE and each of the third and fourth semiconductor patterns SP3 and SP4. The gate dielectric layer GI may include one or more of a silicon oxide layer, a silicon oxynitride layer, and a high-k dielectric layer. In some example embodiments, the gate dielectric layer GI may include a silicon oxide layer that directly covers a surface of a corresponding one of the semiconductor patterns SP 1 to SP4, and may also include a high-k dielectric layer on the silicon oxide layer. For example, the gate dielectric layer GI may include a multi-layer of a silicon oxide layer and a high-k dielectric layer.

The high-k dielectric layer may include a high-k dielectric material whose dielectric constant is greater than that of a silicon oxide layer. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

The lower gate electrode LGE may include a first work-function metal on the first and second semiconductor patterns SP 1 and SP2. The upper gate electrode UGE may include a second work-function metal on the third and fourth semiconductor patterns SP3 and SP4. For example, the first work-function metal may be an n-type work-function metal such as metal carbide (e.g., TiC, AlC, or TiAlC). The second work-function metal may include a p-type work-function metal such as metal nitride (e.g., TiN).

As discussed above, the lower gate electrode LGE and the upper gate electrode UGE may include different materials from each other. In an embodiment, a boundary may be present between the lower gate electrode LGE and the upper gate electrode UGE, and the boundary may distinguish the lower and upper gate electrodes LGE and UGE from each other. For example, the lower gate electrode LGE and the upper gate electrode UGE may be individually formed by different processes from each other. The lower gate electrode LGE and the upper gate electrode UGE may be in direct contact with and connected to each other to constitute one common gate electrode GE.

A cutting structure LCT may be provided to penetrate the gate electrode GE. The cutting structure LCT may penetrate the upper gate electrode UGE and the lower gate electrode LGE. The cutting structure LCT may separate the gate electrode GE of the bit cell CE depicted in FIGS. 2A and 2B from a gate electrode of another bit cell CE. The cutting structure LCT may include a dielectric material, such as a silicon oxide layer, a silicon nitride layer, or a combination thereof.

Referring to FIG. 3B, the upper active contact UAC and the lower active contact LAC may vertically overlap each other, which upper and lower active contacts UAC and LAC constitute nodes N1 and N2. A connection structure CNS may be provided between the upper active contact UAC and the lower active contact LAC that constitute the nodes N1 and N2. The connection structure CNS may vertically and electrically connect the upper active contact UAC to the lower active contact LAC.

A lower interlayer dielectric layer 210 may be provided on the second surface 100B of the substrate 100. A backside metal layer BSM may be provided in the lower interlayer dielectric layer 210. The backside metal layer BSM may include a power line VDD, a ground line VSS, a first bit line BL1, and a second bit line BL2. Each wiring line in the backside metal layer BSM may include metal, for example one or more of copper (Cu), aluminum (Al), ruthenium (Ru), cobalt (Co), tungsten (W), and molybdenum (Mo).

The backside metal layer BSM may further include lower vias LVI. The lower vias LVI may correspondingly connect the wiring lines VSS, BL1, and BL2 in the backside metal layer BSM to the lower active contacts LAC. One of the lower vias LVI may penetrate the lower interlayer dielectric layer 210, the substrate 100, the first interlayer dielectric layer 110, and the second interlayer dielectric layer 120, thereby connecting the power line VDD and the upper active contact UAC to each other. For example, the lower via LVI may include metal selected from copper (Cu), aluminum (Al), ruthenium (Ru), cobalt (Co), tungsten (W), and molybdenum (Mo).

In some example embodiments, additional backside metal layers may further be provided below the backside metal layer BSM. For example, the additional backside metal layers may include a power delivery network. The power delivery network may include a plurality of lower wiring lines electrically connected to the ground and power lines VSS and VDD. For example, the power delivery network may include a wiring network for applying a ground voltage to the ground line VSS. The power delivery network may include a wiring network for applying a power voltage to the power line VDD.

A third interlayer dielectric layer 130 may be provided on the second interlayer dielectric layer 120. A first metal layer M1 may be provided in the third interlayer dielectric layer 130. The first metal layer M1 may include a word line WL, a first node line ND1, a second node line ND2, and a power line VDD. Alternatively, the power line VDD may be omitted in the first metal layer M1. Each wiring line in the first metal layer M1 may include metal, for example one or more of copper (Cu), aluminum (Al), ruthenium (Ru), cobalt (Co), tungsten (W), and molybdenum (Mo).

The first metal layer M1 may further include upper vias UVI that are correspondingly provided below wiring lines. One of the upper vias UVI may penetrate the third interlayer dielectric layer 130, the second interlayer dielectric layer 120, and the gate capping pattern GP, thereby being connected to the upper gate electrode UGE. Another of the upper vias UVI may penetrate the third interlayer dielectric layer 130 to have connection with the upper active contact UAC. For example, the upper via UVI may include metal for example one or more of copper (Cu), aluminum (Al), ruthenium (Ru), cobalt (Co), tungsten (W), and molybdenum (Mo).

Additional metal layers (e.g., M2, M3, M4, etc.) may be stacked on the first metal layer M1. The first metal layer M1 and metal layers (e.g., M2, M3, M4, etc.) on the first metal layer M1 may constitute a back-end-of-line (BEOL) layer of a semiconductor device.

According to various example embodiments of inventive concepts, a power line for supplying the bit cell CE with a ground voltage and a power voltage may be provided in the shape of a power delivery network layer disposed below the substrate 100. Therefore, a power delivery network may be omitted in a back-end-of-line (BEOL) layer including the first metal layer M1. As no power delivery network is present in a BEOL layer, there may be a reduction in complexity of wiring lines in the BEOL layer. In addition, sizes of wiring lines in the BEOL layer may be increased to decrease resistance in the BEOL layer.

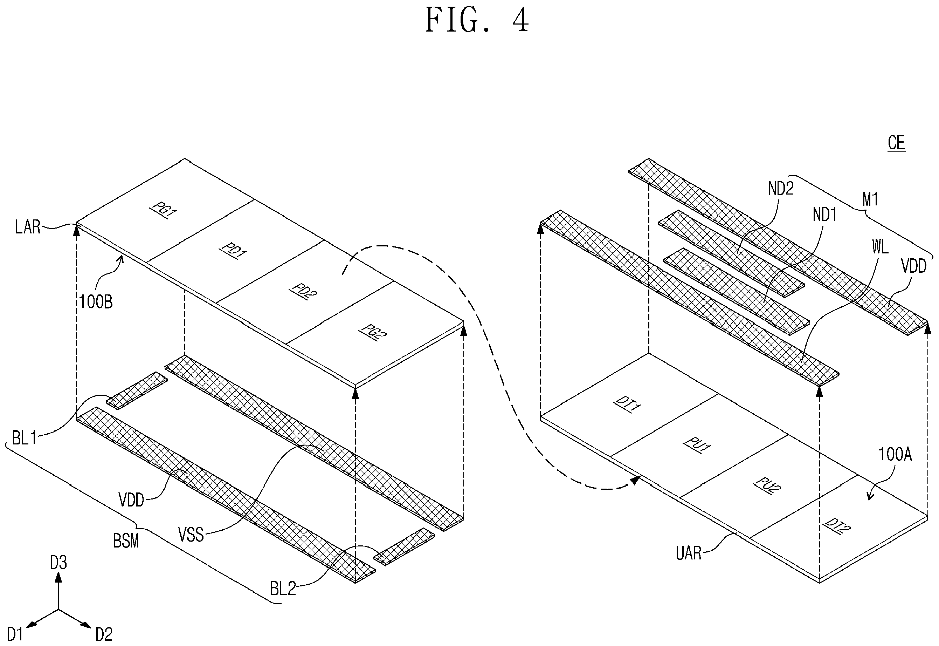

FIG. 4 illustrates a simplified perspective view showing layers included in a bit cell according to various example embodiments of inventive concepts. Representatively, with reference to FIG. 4, the following will describe in detail the bit cell CE.

The substrate 100 may have a first surface 100A and a second surface 100B that stands opposite to the first surface 100A. The first surface 100A may be a front surface of the substrate 100. The second surface 100B may be a rear surface of the substrate 100.

A first metal layer M1 may be provided on the first surface 100A of the substrate 100. The first metal layer M1 may be a lowermost metal layer of a BEOL layer. A backside metal layer BSM may be provided on the second surface 100B of the substrate 100. The backside metal layer BSM may be an uppermost metal layer of a backside power delivery network. Each of the first metal layer M1 and the backside metal layer BSM may include at least one of conductive metal nitride (e.g., titanium nitride or tantalum nitride) and metal (e.g., titanium, tantalum, tungsten, copper, or aluminum).

The backside metal layer BSM may include a power line VDD and a ground line VSS. Each of the power line VDD and the ground line VSS may have a linear shape that extends in the second direction D2. The backside metal layer BSM may further include a first bit line BL1 and a second bit line BL2 that are disposed between the power and ground lines VDD and VSS. When viewed in plan, each of the first bit line BL1 and the second bit line BL2 may have an island shape.

The first metal layer M1 may include a word line WL, a power line VDD, a first node line ND1, and a second node line ND2. Each of the word line WL and the power line VDD may have a linear shape that extends in the second direction D2. The first node line ND1 and the second node line ND2 may be provided between the word line WL and the power line VDD. Each of the first node line ND1 and the second node line ND2 may have a bar shape that extends in the second direction D2. The first node line ND1 may correspond to the first node N1 of FIG. 1, and the second node line ND2 may correspond to the second node N2 of FIG. 1.

The first node line ND1 may electrically connect a common source/drain of the first pull-up and pull-down transistors PU1 and PD1 to a common gate of the second pull-up and pull-down transistors PU2 and PD2. The second node line ND2 may electrically connect a common source/drain of the second pull-up and pull-down transistors PU2 and PD2 to a common gate of the first pull-up and pull-down transistors PU1 and PD1.

The bit cell CE may include a lower active region LAR as a bottom tier and an upper active region UAR as a top tier. The lower active region LAR may include four NMOSFETs linearly arranged along the second direction D2. For example, the lower active region LAR may include a first pass-gate transistor PG1, a first pull-down transistor PD1, a second pull-down transistor PD2, and a second pass-gate transistor PG2 that are sequentially arranged along the second direction D2.

The upper active region UAR may include four PMOSFETs linearly arranged along the second direction D2. For example, the upper active region UAR may include a first dummy transistor DT 1, a first pull-up transistor PU1, a second pull-up transistor PU2, and a second dummy transistor DT2.

The upper active region UAR may be disposed to overlap the lower active region LAR. Therefore, the first pull-down transistor PD1 and the first pull-up transistor PU1 may vertically overlap each other. The second pull-down transistor PD2 and the second pull-up transistor PU2 may vertically overlap each other. The first pass-gate transistor PG1 and the first dummy transistor DT1 may vertically overlap each other. The second pass-gate transistor PG2 and the second dummy transistor DT2 may vertically overlap each other.

Referring back to FIG. 3A, the upper source/drain pattern USD may be omitted which corresponds to each of the first and second dummy transistors DT 1 and DT2. For example, a blocking layer BLL may be provided on each of opposite sides of the upper active region UAR. The blocking layer BLL may prevent the upper source/drain pattern USD from growing from the seed layer SDL and the third and fourth semiconductor patterns SP3 and SP4.

Referring back to FIGS. 2A, 2B, and 3A to 3D, first to fifth lower active contacts LAC1 to LAC5 may be provided below the lower active region LAR as a bottom tier. First to third upper active contacts UAC1 to UAC3 may be provided on the upper active region UAR as a top tier. First to fourth gate electrodes GE1 to GE4 may be provided on the lower and upper active regions LAR and UAR.

Referring to FIG. 3B, the first upper active contact UAC1 and the second lower active contact LAC2 may be electrically connected through the connection structure CNS. The connection structure CNS may be a vertical via that extends vertically. The first upper active contact UAC1 may be electrically connected through the upper via UVI to the first node line ND1. As a result, the first upper active contact UAC1 and the second lower active contact LAC2 may together constitute or correspond to the first node N1 of FIG. 1.

Referring to FIGS. 3A and 3C, the third upper gate electrode UGE3 and the third lower gate electrode LGE3 may be connected to constitute one third gate electrode GE3. The first node line ND1 may be connected through other upper via UVI to the third upper gate electrode UGE3. For example, a gate of the second pull-up transistor PU2 and a gate of the second pull-down transistor PD2 may be connected through the first node line ND1 to the first node N1 of FIG. 1.

Referring to FIGS. 2A and 2B, the third upper active contact UAC3 and the fourth lower active contact LAC4 may be electrically connected through the connection structure CNS. The third upper active contact UAC3 may be electrically connected through the upper via UVI to the second node line ND2. As a result, the third upper active contact UAC3 and the fourth lower active contact LAC4 may together constitute the second node N2 of FIG. 1. The second node line ND2 may be connected through other upper via UVI to the second gate electrode GE2. For example, a gate of the first pull-up transistor PU1 and a gate of the first pull-down transistor PD1 may be connected through the second node line ND2 to the second node N2 of FIG. 1.

Referring to FIG. 3D, the second upper active contact UAC2 may be electrically connected through the lower via LVI to the power line VDD of the backside metal layer BSM. The second upper active contact UAC2 may be electrically connected through the upper via UVI to the power line VDD of the first metal layer M1. For example, the first and second pull-up transistors PU1 and PU2 may be electrically connected through the second upper active contact UAC2 to the power line VDD.

The third lower active contact LAC3 may be electrically connected through the lower via LVI to the ground line VSS of the backside metal layer BSM. The first and second pull-down transistors PD1 and PD2 may be electrically connected through the third lower active contact LAC3 to the ground line VSS.

In some example embodiments, the second upper active contact UAC2 may include a first portion PA1 that vertically overlaps all or at least part of the third lower active contact LAC3 and a second portion PA2 other than the first portion PA1. The second portion PA2 may not vertically overlap the third lower active contact LAC3. The lower via LVI connected to the power line VDD may be coupled to the second portion PA2. The upper via UVI connected to the power line VDD may be coupled to the second portion PA2.

The first node N1 and the second node N2 of the bit cell CE according various example embodiments may be respectively provided to the first node line ND1 and the second node line ND2 in the first metal layer M1. The first node line ND1 and the second node line ND2 may be disposed adjacent to each other.

An SRAM cell according to some example embodiments may include a stack structure in which lower transistors are arranged in a 1x4 arrangement and upper transistors are arranged in a 1x4 arrangement. Therefore, various example embodiments may reduce a cell area and/or may increase an integration of device.

In an SRAM cell according to various example embodiments, a node and a word line may be disposed on a front surface of a substrate, and a power line and a ground line may be disposed on a rear surface of the substrate. In this configuration, wiring lines of the SRAM cell according to example embodiments may be divided and disposed on rear and front surfaces of the substrate, and thus it may be possible to induce a reduction in cell area and complexity in a BEOL layer.

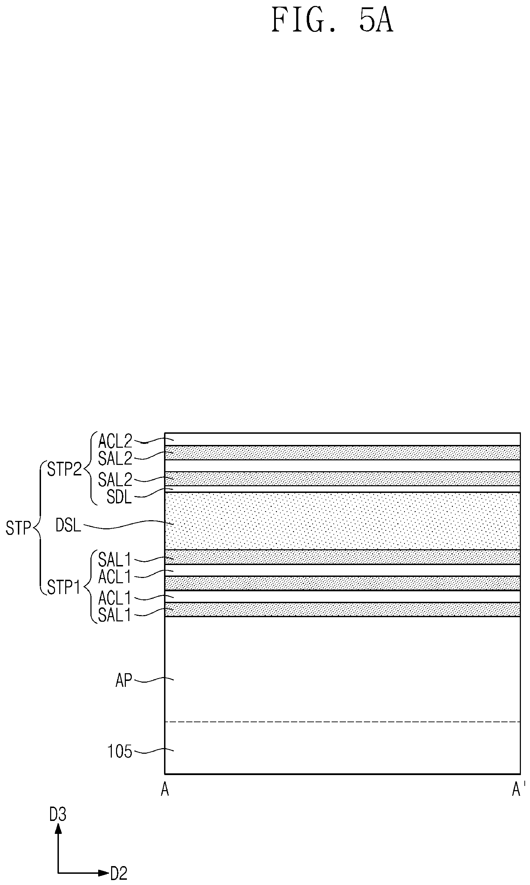

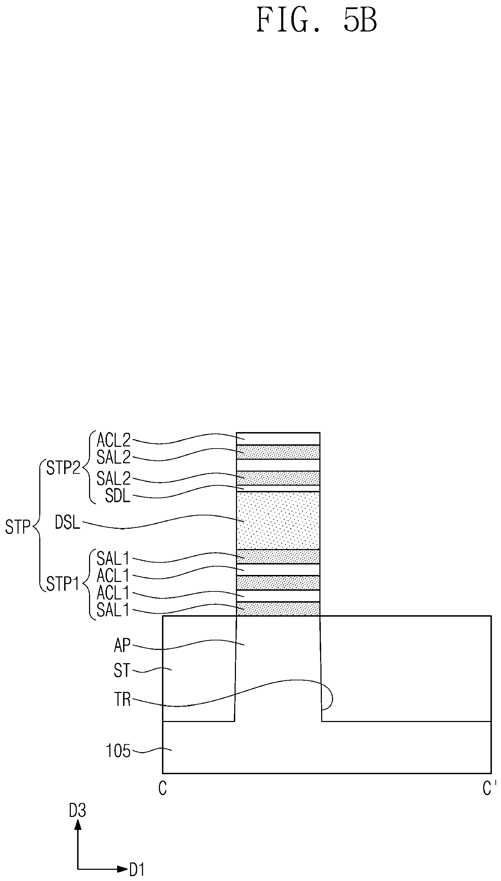

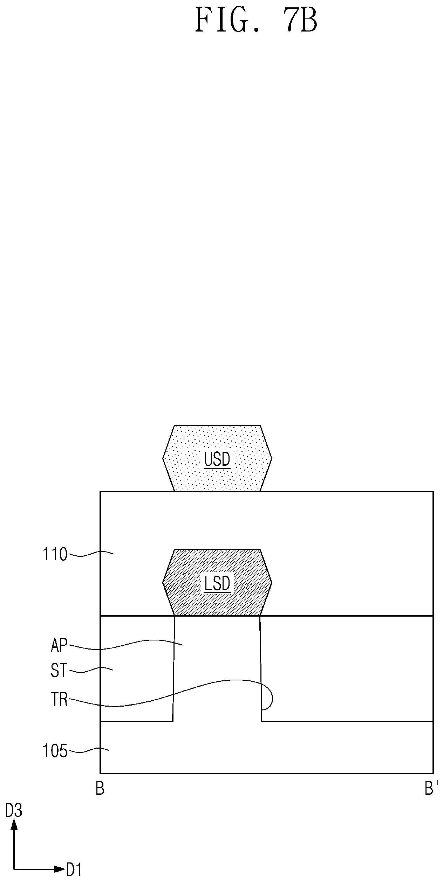

FIGS. 5A to 9C illustrate cross-sectional views showing a method of fabricating a semiconductor memory device according to various example embodiments of inventive concepts. FIGS. 5A, 6A, 7A, 8A, and 9A illustrate cross-sectional views taken along line A-A' of FIGS. 2A and 2B. FIGS. 7B, 8B, and 9B illustrate cross-sectional view taken along line B-B' of FIGS. 2A and 2B. FIGS. 5B, 6B, 8C, and 9C illustrate cross-sectional views taken along line C-C' of FIGS. 2A and 2B.

Referring to FIGS. 5A and 5B, a semiconductor substrate 105 may be provided which includes a bit cell CE. The semiconductor substrate 105 may include one or more of silicon (Si), germanium (Ge), and silicon-germanium (SiGe). The semiconductor substrate 105 may be a wafer; however, example embodiments are not limited thereto.

First sacrificial layers SAL1 and first active layers ACL1 may be alternately stacked on the semiconductor substrate 105. The first sacrificial layers SAL 1 may include one of silicon (Si), germanium (Ge), and silicon-germanium (SiGe), and the first active layers ACL1 may include another of silicon (Si), germanium (Ge), and silicon-germanium (SiGe). For example, the first sacrificial layers SAL1 may include silicon-germanium (SiGe), and the first active layers ACL1 may include silicon (Si). Each of the first sacrificial layers SAL1 may have a germanium concentration of about 10 at% to about 30 at%. A thickness of each of the first sacrificial layers SAL1 may be the same as each other, or at least one may be different than another one. A thickness of each of the first active layers ACL1 may be the same as each other, or at least one may be different than (e.g., greater than or less than) another one.

A separation layer DSL may be formed on an uppermost first sacrificial layer SAL1. In some example embodiments, the separation layer DSL may have a thickness greater than that of the first sacrificial layer SAL 1. The separation layer DSL may include silicon (Si) or silicon-germanium (SiGe). When the separation layer DSL includes silicon-germanium (SiGe), the separation layer DSL may have a germanium concentration greater than that of the first sacrificial layer SAL 1. For example, the separation layer DSL may have a germanium concentration of about 40 at% to about 90 at%.

A seed layer SDL may be formed on the separation layer DSL. The seed layer SDL may include the same material as that of the first active layer ACL1. Second sacrificial layers SAL2 and second active layers ACL2 may be alternately stacked on the seed layer SDL. Each of the second sacrificial layers SAL2 may include the same material as that of the first sacrificial layer SAL1, and each of the second active layers ACL2 may include the same material as that of the first active layer ACL 1. The separation layer DSL may be interposed between the first sacrificial layer SAL1 and the seed layer SDL. A thickness of each of the second sacrificial layers SAL2 may be the same as each other, or at least one may be different than another one, and may or may not be the same as those of the first sacrificial layers SAL1. A thickness of each of the second active layers ACL2 may be the same as each other, or at least one may be different than (e.g., greater than or less than) another one, and may or may not be the same as those of the second sacrificial layer SAL2.

A stack pattern STP may be formed by patterning the first and second sacrificial layers SAL1 and SAL, the first and second active layers ACL1 and ACL2, and the separation layer DSL that are stacked on each other. The formation of the stack pattern STP may include forming a hardmask pattern on an uppermost second active layer ACL2, and using the hardmask pattern as an etching mask to etch the stacked layers SAL1, SAL2, ACL1, ACL2, SDL, and DSL on the semiconductor substrate 105, e.g., with a dry etching process.

During the formation of the stack pattern STP, an upper portion of the semiconductor substrate 105 may be patterned to form a trench TR that defines an active pattern AP. Each of the stack pattern STP and the active pattern AP may have a linear shape that extends in a second direction D2. The active pattern AP may vertically overlap the stack pattern STP.

The stack pattern STP may include a lower stack pattern STP1 on the active pattern AP, an upper stack pattern STP2 on the lower stack pattern STP1, and a separation layer DSL between the lower and upper stack patterns STP1 and STP2. The lower stack pattern STP1 may include the first sacrificial layers SAL1 and the first active layers ACL1 that are alternately stacked. The upper stack pattern STP2 may include the seed layer SDL and may also include the second sacrificial layers SAL2 and the second active layers ACL2 that are alternately stacked on the seed layer SDL.

A device isolation layer ST filling the trench TR may be formed on the semiconductor substrate 105. For example, a dielectric layer may be formed on an entire surface of the semiconductor substrate 105, covering the active pattern AP and the stack patterns STP. The dielectric layer may be recessed until the stack patterns STP are exposed, and thus the device isolation layer ST may be formed. The device isolation layer ST may include an oxide; however, example embodiments are not limited thereto.

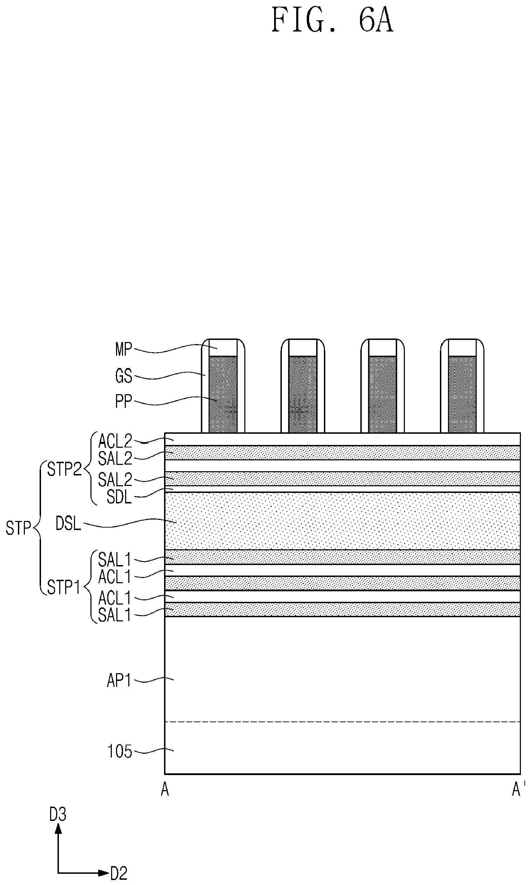

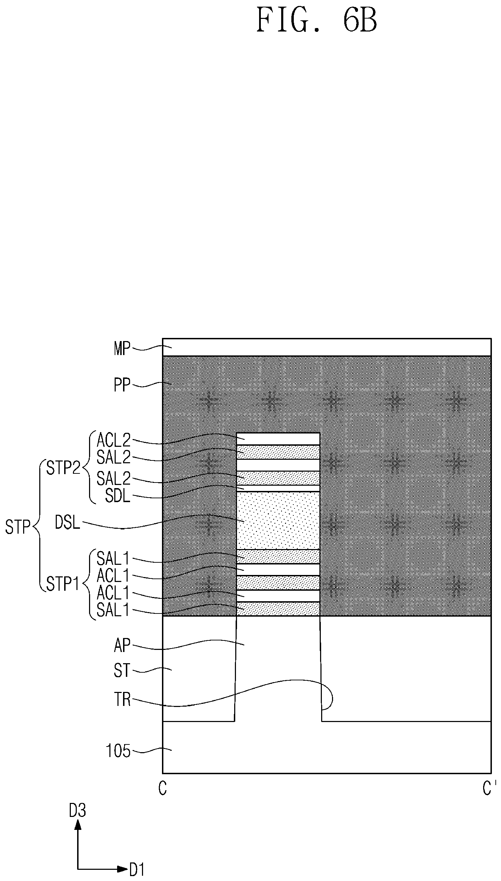

Referring to FIGS. 6A and 6B, a plurality of sacrificial patterns PP may be formed to run across the stack pattern STP. Each of the sacrificial patterns PP may be formed to have a linear shape that extends in a first direction D1. For example, the formation of the sacrificial patterns PP may include forming a sacrificial layer on the entire surface of the semiconductor substrate 105, forming hardmask patterns MP on the sacrificial layer, and using the hardmask patterns MP as an etching mask to pattern the sacrificial layer. The sacrificial layer may include one or more of amorphous silicon and polysilicon such as doped polysilicon.

A pair of gate spacers GS may be formed on opposite sidewalls of each of the sacrificial patterns PP. For example, a spacer layer may be conformally formed on the entire surface of the semiconductor substrate 105. The spacer layer may cover the sacrificial pattern PP and the hardmask pattern MP. For example, the spacer layer may include at least one selected from SiCN, SiCON, and SiN. The spacer layer may be anisotropically etched, e.g., with a dry etching process, to form the gate spacers GS.

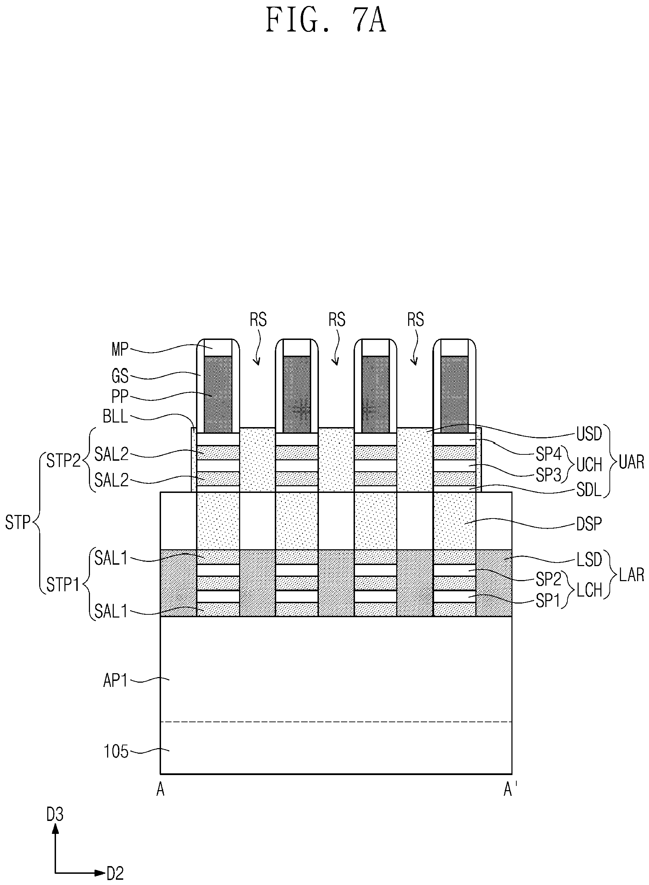

Referring to FIGS. 7A and 7B, the gate spacers GS and the hardmask pattern MP may be used as an etching mask to perform an etching process on the stack pattern STP. The etching process may form a recess RS between the sacrificial patterns PP. The recess RS may be defined between the lower stack patterns STP1 that are adjacent to each other in the second direction D2. The recess RS may be defined between the upper stack patterns STP2 that are adjacent to each other in the second direction D2.

In some example embodiments, when the separation layer DSL includes silicon-germanium (SiGe), the separation layer DSL may be replaced with a silicon-based dielectric material. The separation layer DSL exposed by the recess RS may be selectively removed, and a dummy channel pattern DSP may be formed in a region where the separation layer DSL is removed. The dummy channel pattern DSP may include a silicon-based dielectric material (e.g., silicon nitride).

A lower source/drain pattern LSD may be formed between the lower stack patterns STP1. For example, the lower source/drain pattern LSD may be formed by performing a first selective epitaxial growth (SEG) process in which an exposed sidewall of the lower stack pattern STP1 and an exposed top surface of the active pattern AP are used as a seed layer. The lower source/drain pattern LSD may grow from a seed, or the first active layers ACL 1 and the active pattern AP that are exposed by the recess RS. For example, the first SEG process may include chemical vapor deposition (CVD) and/or molecular beam epitaxy (MBE).

During the first SEG process, impurities may be in-situ doped into the lower source/drain pattern LSD. Alternatively or additionally, after the formation of the lower source/drain pattern LSD, impurities may be implanted into the lower source/drain pattern LSD. The lower source/drain pattern LSD may be doped to have a first conductivity type (e.g., n-type).

A lower channel pattern LCH may be constituted by the first active layers ACL1 interposed between a pair of lower source/drain patterns LSD. For example, the first active layers ACL1 may be formed into first and second semiconductor patterns SP1 and SP2 of the lower channel pattern LCH. The lower channel patterns LCH and the lower source/drain patterns LSD may constitute a lower active region LAR as a bottom tier of a three-dimensional device.

A first interlayer dielectric layer 110 may be formed on the lower source/drain patterns LSD. The first interlayer dielectric layer 110 may be recessed to expose the upper stack patterns STP2. An upper source/drain pattern USD may be formed between the exposed upper stack patterns STP2. For example, the upper source/drain pattern USD may be formed by performing a second SEG process in which a sidewall of the upper stack pattern STP2 is used as a seed layer. The upper source/drain pattern USD may grow from a seed, and/or the second active layers ACL2 and the seed layer SDL that are exposed by the recess RS. The upper source/drain pattern USD may be doped to have a second conductivity type (e.g., p-type) different from the first conductivity type.

A blocking layer BLL may be formed on a sidewall of an outermost one among the upper stack patterns STP2. The blocking layer BLL may prevent growth of the upper source/drain pattern USD. Therefore, the upper source/drain pattern USD may not be formed on the sidewall of the outermost upper stack pattern STP2.

An upper channel pattern UCH may be constituted by the second active layers ACL2 interposed between a pair of upper source/drain patterns USD. For example, the second active layers ACL2 may be formed into third and fourth semiconductor patterns SP3 and SP4 of the upper channel pattern UCH. The upper channel patterns UCH and the upper source/drain patterns USD may constitute an upper active region UAR as a top tier of a three-dimensional device.

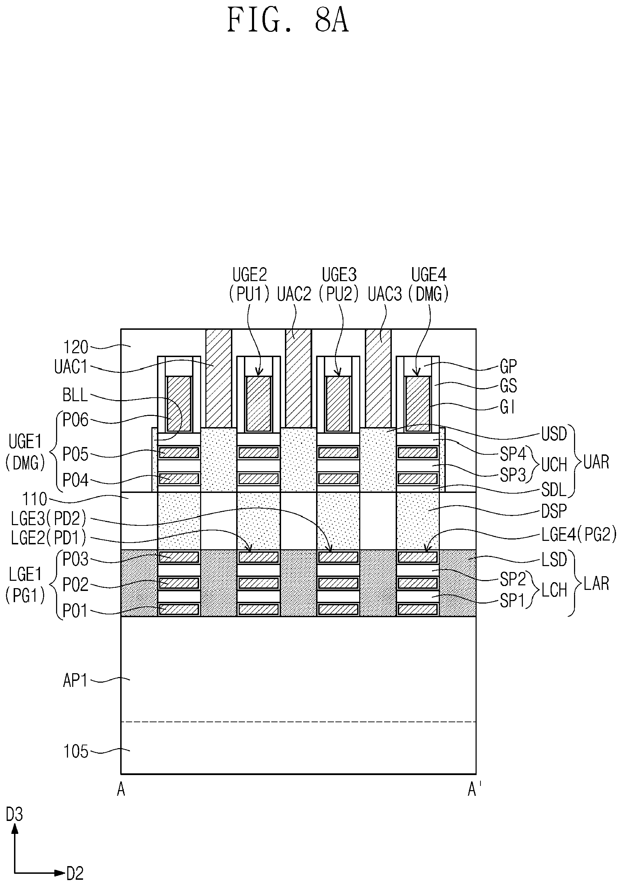

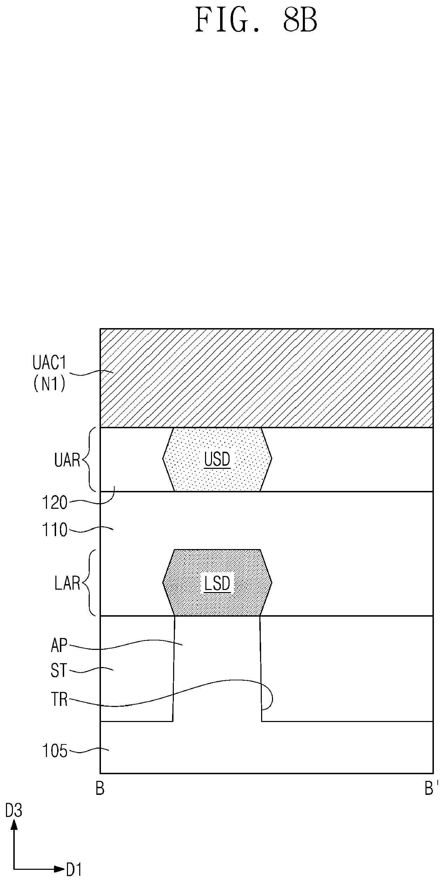

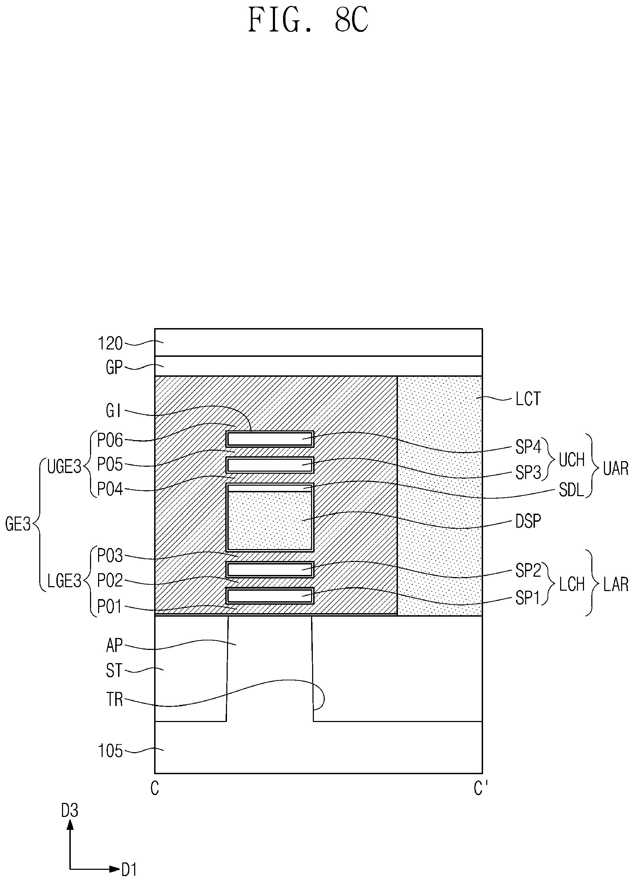

Referring to FIGS. 8A to 8C, a second interlayer dielectric layer 120 may be formed on the upper source/drain patterns USD. The second interlayer dielectric layer 120 may be planarized until a top surface of the sacrificial pattern PP is exposed. An etch-back and/or a chemical mechanical polishing (CMP) process may be employed to planarize the second interlayer dielectric layer 120. The hardmask patterns MP may all be removed during the planarization process. As a result, a top surface of the second interlayer dielectric layer 120 may be substantially coplanar with that of the sacrificial pattern PP and those of the gate spacers GS.

The exposed sacrificial pattern PP may be selectively removed. The removal of the sacrificial pattern PP may include performing a wet etching process using an etchant that selectively etches polysilicon. The removal of the sacrificial pattern PP may expose the first and second sacrificial layers SAL1 and SAL2.

An etching process may be performed in which the first and second sacrificial layers SAL1 and SAL2 are selectively etched, such that only the first and second sacrificial layers SAL1 and SAL2 may be removed while leaving the first to fourth semiconductor patterns SP1 to SP4 and the dummy channel pattern DSP. The etching process may have an etch rate with respect to silicon-germanium. For example, the etching process may have a high etch rate with respect to silicon-germanium whose germanium concentration is greater than about 10 at%.

A gate dielectric layer GI may be conformally formed in a region where the sacrificial pattern PP and the first and second sacrificial layers SAL1 and SAL2 are removed. A lower gate electrode LGE may be formed on the gate dielectric layer GI of the lower active region LAR. The lower gate electrode LGE may include a first portion PO1 between the active pattern AP and the first semiconductor pattern SP1, a second portion PO2 between the first semiconductor pattern SP1 and the second semiconductor pattern SP2, and a third portion PO3 between the second semiconductor pattern SP2 and the dummy channel pattern DSP.

An upper gate electrode UGE may be formed on the lower gate electrode LGE. The upper gate electrode UGE may be formed on the gate dielectric layer GI of the upper active region UAR. The upper gate electrode UGE may include a fourth portion PO4 between the dummy channel pattern DSP (or the seed layer SDL) and the third semiconductor pattern SP3, a fifth portion PO5 between the third semiconductor pattern SP3 and the fourth semiconductor pattern SP4, and a sixth portion PO6 on the fourth semiconductor pattern SP4.

In some example embodiments, the upper gate electrode UGE and the lower gate electrode LGE may be connected to constitute one gate electrode GE. For example, the third upper gate electrode UGE3 and the third lower gate electrode LGE3 may be connected to constitute one third gate electrode GE3.

A cutting structure LCT may be formed to penetrate the gate electrode GE. The cutting structure LCT may separate the gate electrode GE of the bit cell CE depicted in FIGS. 2A and 2B from a gate electrode of another bit cell CE.

A gate capping pattern GP may be formed on the upper gate electrodes UGE and the cutting structure LCT. A second interlayer dielectric layer 120 may be additionally deposited on the gate capping pattern GP. An upper active contact UAC may be formed to penetrate the second interlayer dielectric layer 120 to be coupled to the upper source/drain pattern USD.

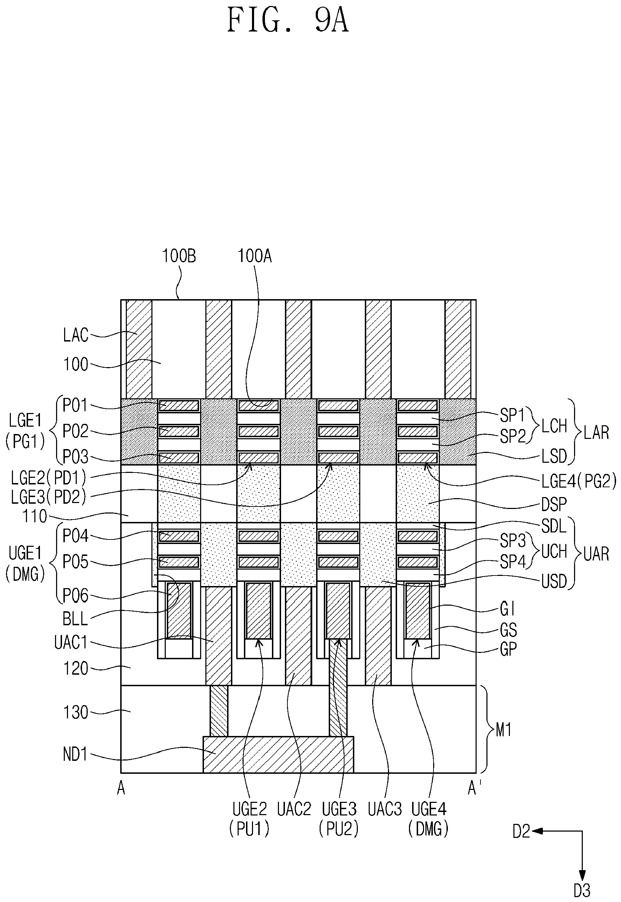

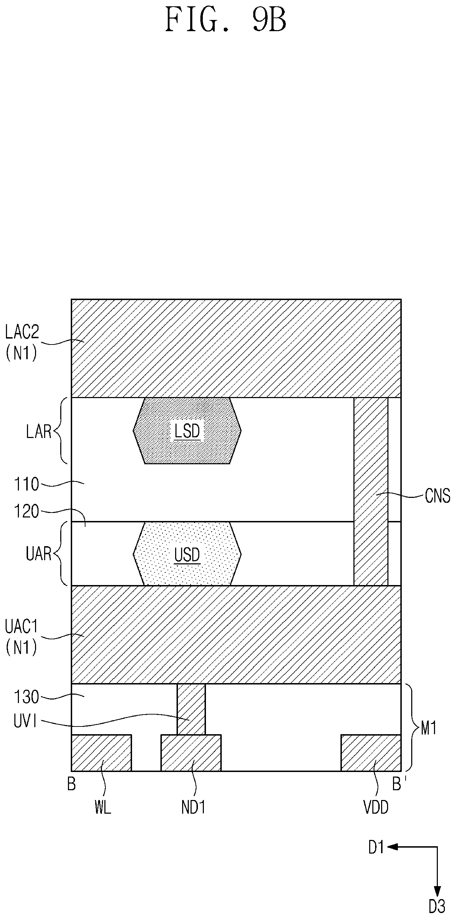

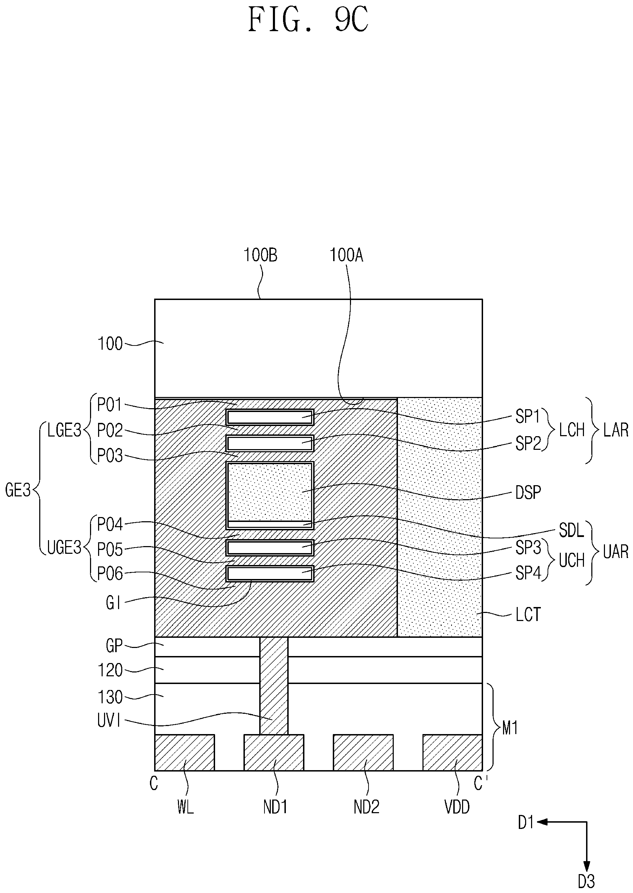

Referring to FIGS. 9A to 9C, a third interlayer dielectric layer 130 may be formed on the second interlayer dielectric layer 120. A first metal layer M1 may be formed in the third interlayer dielectric layer 130. Upper vias UVI may be formed to electrically connect the first metal layer M1 and the upper gate electrode UGE to each other and the first metal layer M1 and the upper active contact UAC to each other. A back-end-of-line (BEOL) layer including additional metal layers (e.g., M2, M3, M4, etc.) may be formed on the first metal layer M1.

The semiconductor substrate 105 may be turned upside down to expose a rear surface of the semiconductor substrate 105. In some example embodiments, the front surface of the semiconductor substrate 105 may be passivated or protect, e.g., with a photoresist material (not illustrated); however, example embodiments are not limited thereto. The exposed semiconductor substrate 105 may be selectively removed. Therefore, the lower active region LAR and the device isolation layer ST may be exposed.

A substrate 100 may be formed on the exposed lower active region LAR. The substrate 100 may be formed of a silicon-based dielectric material (e.g., one or more of silicon oxide, silicon oxynitride, or silicon nitride). In an embodiment, the substrate 100 may be formed of the same material as that of the device isolation layer ST.

A lower active contact LAC may be formed to penetrate the substrate 100 to be coupled to the lower source/drain pattern LSD. A connection structure CNS may be formed to penetrate the first and second interlayer dielectric layers 110 and 120 to connect the lower active contact LAC to the upper active contact UAC. For example, the connection structure CNS may be formed between a first upper active contact UAC 1 and a second lower active contact LAC2.

Referring back to FIGS. 3A to 3D, a lower interlayer dielectric layer 210 may be formed on a second surface 100B of the substrate 100. A backside metal layer BSM may be formed on the lower interlayer dielectric layer 210. A lower via LVI may be formed to electrically connect the backside metal layer BSM to the lower active contact LAC. A power delivery network layer may be formed on the backside metal layer BSM.

The following will describe various example embodiments. In example embodiments that follows, a detailed description of technical features repetitive to those discussed with reference to FIGS. 1 to 4 will be omitted, and a difference thereof will be discussed in detail.

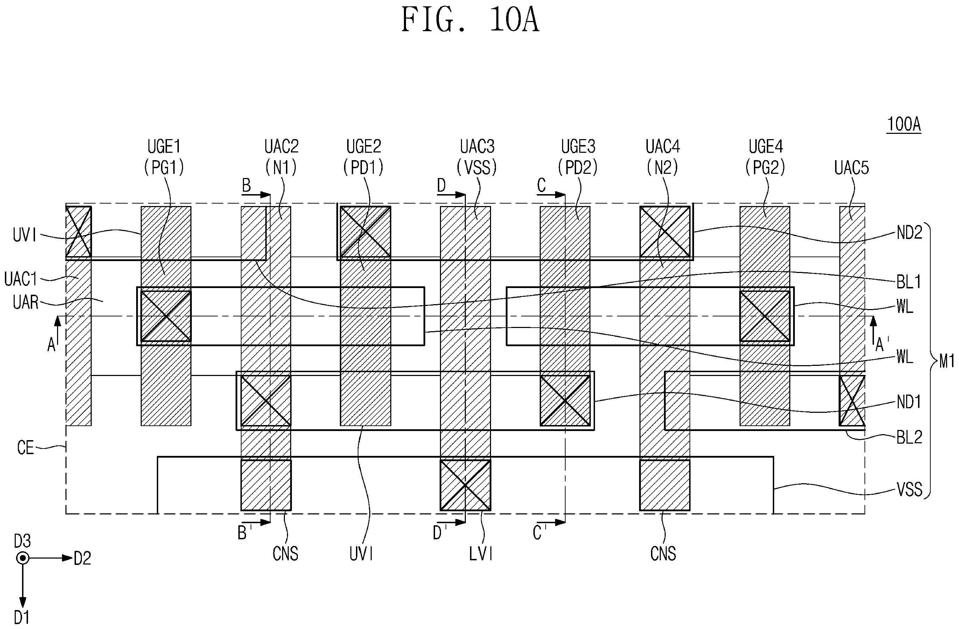

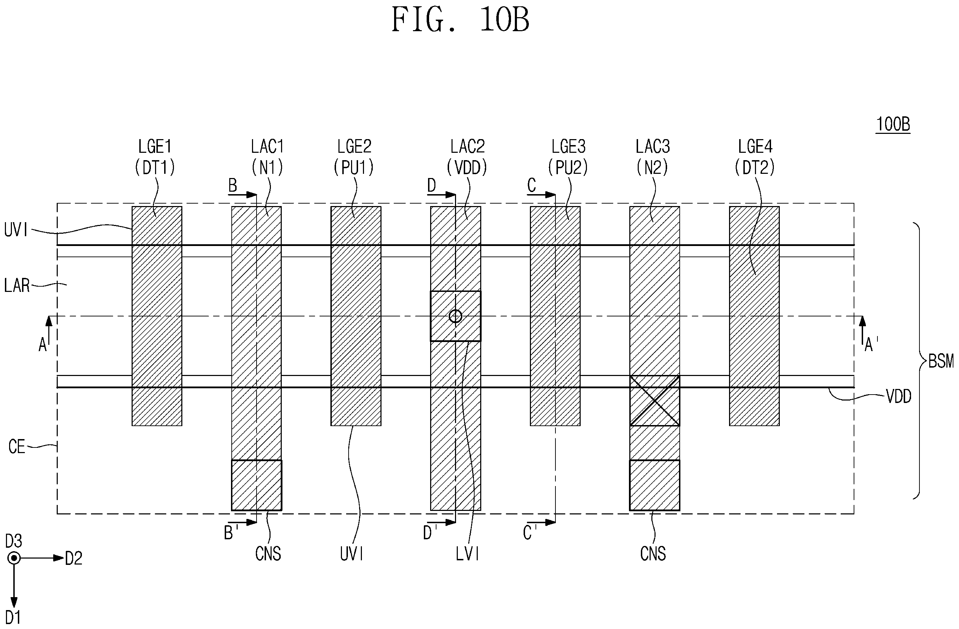

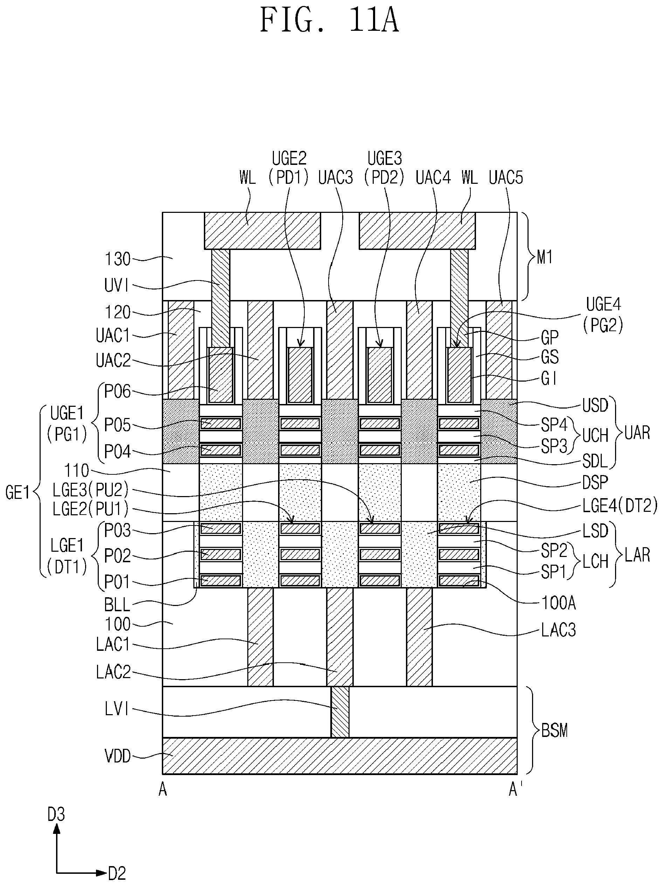

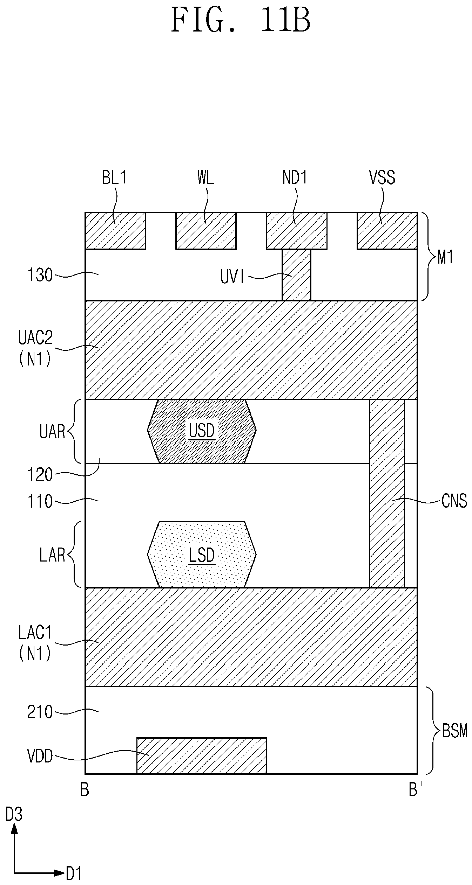

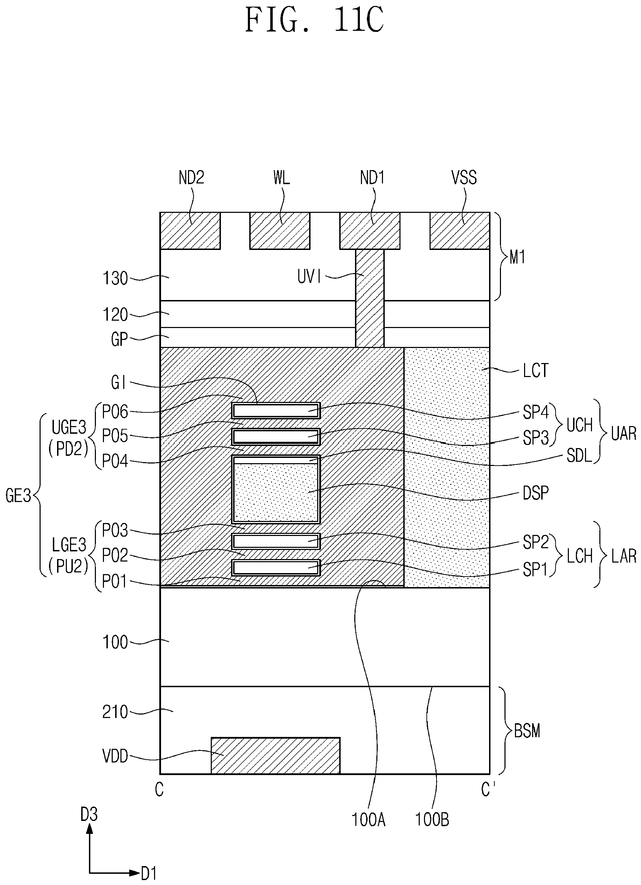

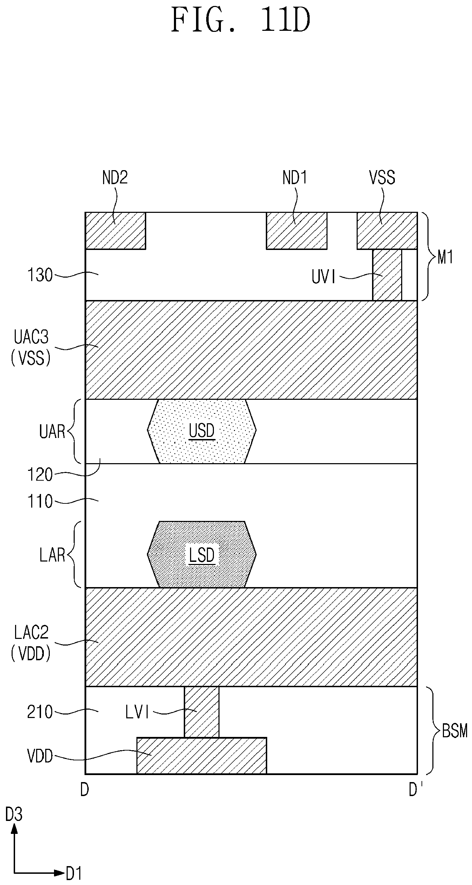

FIG. 10A illustrates a plan view of a first surface of a substrate, showing a semiconductor memory device according to various example embodiments of inventive concepts. FIG. 10B illustrates a plan view of a second surface of a substrate, showing a semiconductor memory device according to various example embodiments of inventive concepts. FIG. 11A illustrates a cross-sectional view taken along line A-A' of FIGS. 10A and 10B. FIG. 11B illustrates a cross-sectional view taken along line B-B' of FIGS. 10A and 10B. FIG. 11C illustrates a cross-sectional view taken along line C-C' of FIGS. 10A and 10B. FIG. 11D illustrates a cross-sectional view taken along line D-D' of FIGS. 10A and 10B.

Referring to FIGS. 10A, 10B, and 11A to 11D, there may be provided one bit cell CE according various example embodiments. According various example embodiments, the lower active region LAR may be a PMOSFET region, and the upper active region UAR may be an NMOSFET region. The lower active region LAR may include a first dummy transistor DT 1, a first pull-up transistor PU1, a second pull-up transistor PU2, and a second dummy transistor DT2. The upper active region UAR may include a first pass-gate transistor PG1, a first pull-down transistor PD1, a second pull-down transistor PD2, and a second pass-gate transistor PG2. In some example embodiments, either or both of the first and second dummy transistors DT1 and DT2 may not be electrically active or functional during operation of the SRAM cell.

The first metal layer M1 of the bit cell CE may include a word line WL, a first bit line BL1, a second bit line BL2, a first node line ND1, a second node line ND2, and a ground line VSS. Each of wiring lines in the first metal layer M1 may have a bar shape that extends in the second direction D2.

The first bit line BL1 and the second node line ND2 may be aligned with each other in the second direction D2. The second bit line BL2 and the first node line ND1 may be aligned with each other in the second direction D2. A pair of word lines WL may be disposed between the first and second bit lines BL1 and BL2 and between the first and second node lines ND1 and ND2. The backside metal layer BSM may include one power line VDD.

Referring to FIG. 11A, the lower source/drain pattern LSD may be omitted which corresponds to each of the first and second dummy transistors DT 1 and DT2. For example, a blocking layer BLL may be provided on each of opposite sides of the lower active region LAR. The blocking layer BLL may prevent the lower source/drain pattern LSD from growing from the first and second semiconductor patterns SP1 and SP2.

Referring to FIG. 11B, the second upper active contact UAC2 and the first lower active contact LAC1 may be electrically connected through the connection structure CNS. The second upper active contact UAC2 may be electrically connected through the upper via UVI to the first node line ND1. As a result, the second upper active contact UAC2 and the first lower active contact LAC1 may together constitute the first node N1 of FIG. 1.

Referring to FIG. 11C, the first node line ND1 may be connected through other upper via UVI to the third upper gate electrode UGE3. For example, a gate of the second pull-up transistor PU2 and a gate of the second pull-down transistor PD2 may be connected through the first node line ND1 to the first node N1 of FIG. 1.

Referring to FIG. 11D, the third upper active contact UAC3 may be electrically connected through the upper via UVI to the ground line VSS of the first metal layer M1. The second lower active contact LAC2 may be electrically connected through the lower via LVI to the power line VDD of the backside metal layer BSM. The third upper active contact UAC3 and the second lower active contact LAC2 may vertically overlap each other.

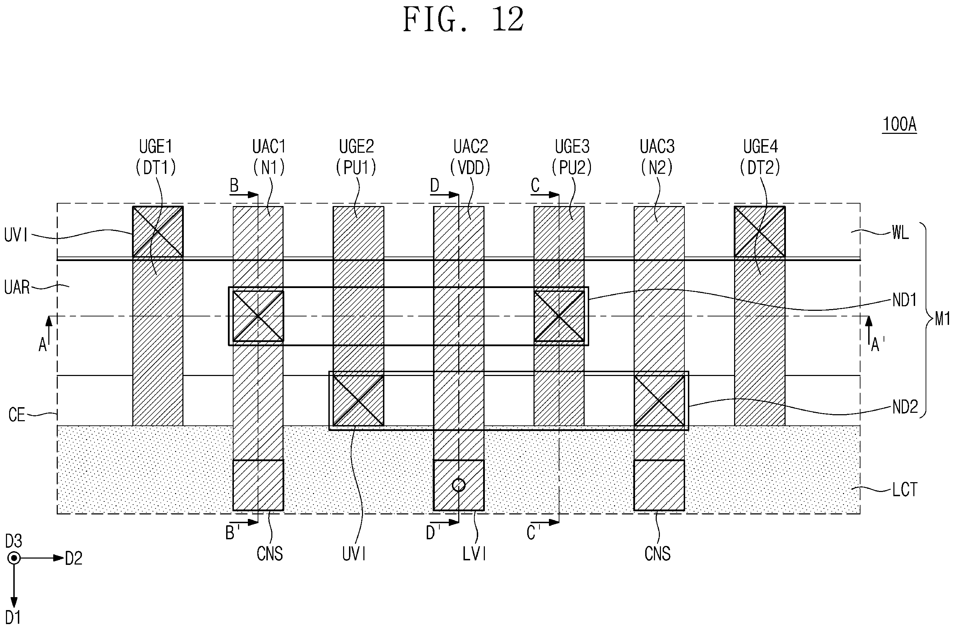

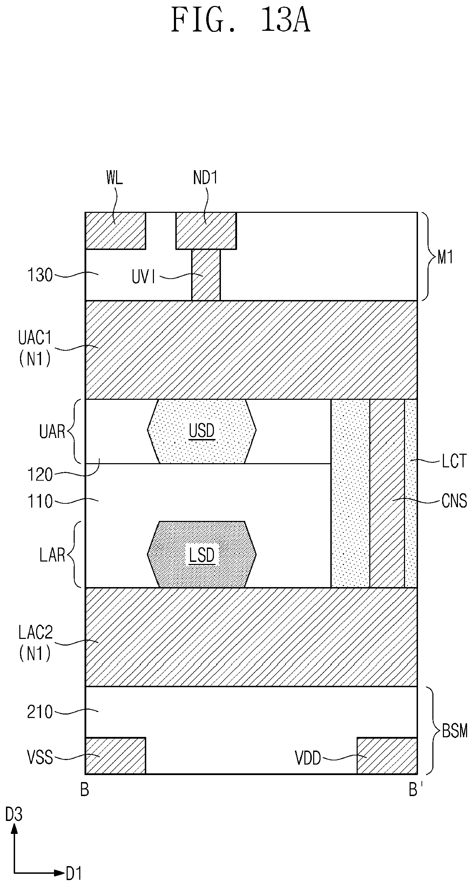

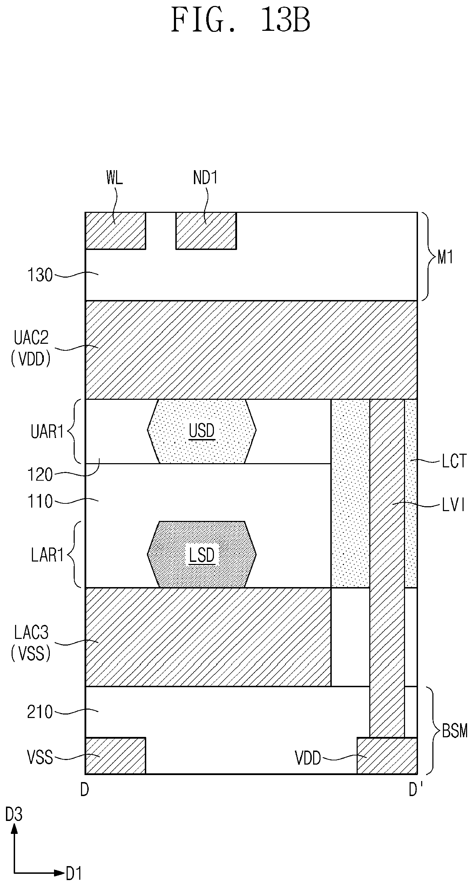

FIG. 12 illustrates a plan view of a first surface of a substrate, showing a semiconductor memory device according to various example embodiments of inventive concepts. FIG. 13A illustrates a cross-sectional view taken along line A-A' of FIG. 12. FIG. 13B illustrates a cross-sectional view taken along line B-B' of FIG. 12.

Referring to FIGS. 12, 13A, and 13B, the cutting structure LCT may be provided on an edge of the bit cell CE. The cutting structure LCT may have a linear shape that extends in the second direction D2. The cutting structure LCT may be configured to cut the gate electrodes GE.

At least a portion of each of the first to third upper active contacts UAC1 to UAC3 may vertically overlap the cutting structure LCT. The cutting structure LCT may be penetrated by the connection structure CNS between the first upper active contact UAC1 and the second lower active contact LAC2. The cutting structure LCT may also be penetrated by the lower via LVI that connects the second upper active contact UAC2 to the power line VDD of the backside metal layer BSM. In an embodiment, the power line VDD may be omitted from the first metal layer M1.

According to various example embodiments, an SRAM cell may include three-dimensional CMOS's arranged in a 1x4 arrangement. In the SRAM cell of example embodiments, as the CMOS's are provided on one active region, the SRAM cell may have a minimum or reduced area and/or a simply structured layout. In conclusion, a semiconductor memory device according to various example embodiments may increase in integration and electrical properties.

Although some example embodiments of inventive concepts have been discussed with reference to accompanying figures, it will be understood that various changes in form and details may be made therein. It therefore will be understood that embodiments described above are just illustrative but not limitative in all aspects. Furthermore example embodiments are not necessarily mutually exclusive with one another. For example, some example embodiments may include one or more features described with reference to one or more figures, and may also include one or more other features described with reference to one or more other figures.

Aspects of the disclosure are set out in the following numbered clauses:
1. A semiconductor memory device, comprising:
   a substrate that has a first surface and a second surface opposite to the first surface;
   a lower active region on the first surface, the lower active region including a first lower gate electrode and a first lower active contact spaced apart from the first lower gate electrode;
   an upper active region on the lower active region, the upper active region including a first upper gate electrode and a first upper active contact spaced apart from the first upper gate electrode, the first upper active contact vertically overlapping at least part of the first lower active contact;
   a first connection structure that vertically connects the first upper active contact to the first lower active contact;
   a first metal layer on the first surface; and
   a backside metal layer on the second surface, wherein
   the first upper gate electrode and the first lower gate electrode are connected and form a first gate electrode, and
   the first metal layer includes a first node line that electrically connects the first gate electrode to the first upper active contact.
2. The device of clause 1, wherein
   the lower active region further includes a second lower gate electrode and a second lower active contact spaced apart from the second lower gate electrode,
   the upper active region further includes a second upper gate electrode and a second upper active contact spaced apart from the second upper gate electrode,
   the second upper active contact vertically overlaps at least part of the second lower active contact,
   the second upper active contact and the second lower active contact are vertically connected through a second connection structure,
   the second upper gate electrode and the second lower gate electrode are connected and form a second gate electrode, and
   the first metal layer further includes a second node line that electrically connects the second gate electrode to the second upper active contact.
3. The device of clause 2, wherein
   the first node line corresponds to an output end of a first inverter of a static random access memory (SRAM) cell, and
   the second node line corresponds to an output end of a second inverter of the SRAM cell.
4. The device of clause 2 or clause 3, wherein the first and second node lines have bar shapes which extend in parallel to each other.
5. The device of any preceding clause, wherein
   the lower active region further includes a second lower active contact between the first lower gate electrode and the first lower active contact,
   the upper active region further includes a second upper active contact between the first upper gate electrode and the first upper active contact,
   the second upper active contact vertically overlaps at least part of the second lower active contact,
   the backside metal layer includes a ground line and a power line,
   the ground line is electrically connected to the second lower active contact, and
   the power line is electrically connected to the second upper active contact.
6. The device of clause 5, further comprising:
   a first lower via that electrically connects the ground line to the second lower active contact; and
   a second lower via that electrically connects the power line to the second upper active contact, wherein
   the second upper active contact includes a first portion that vertically overlaps at least part of the second lower active contact and at least part of a second portion other than the first portion, and
   the second lower via is coupled to the second portion.
7. The device of clause 5 or clause 6, wherein the backside metal layer further includes a bit line.
8. The device of any preceding clause, wherein the first metal layer further includes a word line.
9. The device of any preceding clause, wherein
   the lower active region includes a first semiconductor pattern and a second semiconductor pattern on the first semiconductor pattern,
   the first lower gate electrode at least partly surrounds the first and second semiconductor patterns,
   the upper active region includes a third semiconductor pattern and a fourth semiconductor pattern on the third semiconductor pattern, and
   the first upper gate electrode at least partly surrounds the third and fourth semiconductor patterns.
10. The device of any preceding clause, wherein
   the lower active region includes a first pull-down transistor and a second pull-down transistor,
   the upper active region includes a first pull-up transistor and a second pull-up transistor,
   the first lower active contact is connected to a source/drain of the first pull-down transistor,
   the first upper active contact is connected to a source/drain of the first pull-up transistor,
   the first lower gate electrode is connected to a gate of the second pull-down transistor, and
   the first upper gate electrode is connected to a gate of the second pull-up transistor.
11. A semiconductor memory device, comprising a static random access memory (SRAM) cell on a substrate,
   wherein the SRAM cell includes:
      a backside metal layer;
      a lower active region on the backside metal layer;
      an upper active region on the lower active region; and
      a first metal layer on the upper active region, wherein
   the lower active region includes four first field effect transistors (FETS) arranged in a 1x4 arrangement,
   the upper active region includes four second FETS arranged in a 1x4 arrangement,
   the four first FETS include a first pull-up transistor and a second pull-up transistor,
   the four second FETS include a first pass-gate transistor, a second pass-gate transistor, a first pull-down transistor, and a second pull-down transistor,
   the first pull-down transistor is on the first pull-up transistor, and
   the second pull-down transistor is on the second pull-up transistor.
12. The device of clause 11, wherein the four first FETS further include a first dummy transistor and a second dummy transistor.
13. The device of clause 11 or clause 12, wherein the first metal layer includes:
   a first node line corresponding to an output end of a first inverter of the SRAM cell; and
   a second node line corresponding to an output end of a second inverter of the SRAM cell.
14. The device of clause 13, wherein the first and second node lines have bar shapes which extend in parallel to each other.
15. The device of any of clauses 11 to 14, wherein the backside metal layer includes a power line.
16. A semiconductor memory device, comprising:
   a substrate including a first surface and a second surface opposite to the first surface;
   a lower active region on the first surface, the lower active region including a lower channel pattern and a lower source/drain pattern;
   an upper active region on the lower active region, the upper active region including an upper channel pattern and an upper source/drain pattern;
   a lower gate electrode on the lower channel pattern;
   an upper gate electrode on the upper channel pattern;
   an interlayer dielectric layer on the upper gate electrode and the upper source/drain pattern;
   a lower active contact that penetrates the substrate and is electrically connected to the lower source/drain pattern;
   an upper active contact that penetrates the interlayer dielectric layer and is electrically connected to the upper source/drain pattern, the upper active contact including a first portion that vertically overlaps at least part of the lower active contact and at least part of a second portion other than the first portion;
   a backside metal layer on the second surface of the substrate, the backside metal layer including a ground line and a power line;
   a first metal layer on the interlayer dielectric layer;
   a first lower via that electrically connects the ground line to the lower active contact; and
   a second lower via that electrically connects the power line to the second portion of the upper active contact.
17. The device of clause 16, wherein
   the lower channel pattern includes a first semiconductor pattern and a second semiconductor pattern on the first semiconductor pattern,
   the lower gate electrode at least partly surrounds the first and second semiconductor patterns,
   the upper channel pattern includes a third semiconductor pattern and a fourth semiconductor pattern on the third semiconductor pattern, and
   the upper gate electrode at least partly surrounds the third and fourth semiconductor patterns.
18. The device of clause 16 or clause 17, wherein
   the first metal layer includes an additional power line, and
   the additional power line is electrically connected through an upper via to the upper active contact.
19. The device of any of clauses 16 to 18, further comprising a cutting structure that cuts the lower and upper gate electrodes,
   wherein the cutting structure has a linear shape that extends along the lower and upper active regions, and
   wherein the second lower via penetrates the cutting structure.
20. The device of any of clauses 16 to 19, wherein
   the lower active region includes an NMOSFET region, and
   the upper active region includes a PMOSFET region.

## Claims

1. A semiconductor memory device, comprising:
a substrate that has a first surface and a second surface opposite to the first surface;
a lower active region on the first surface, the lower active region including a first lower gate electrode and a first lower active contact spaced apart from the first lower gate electrode;
an upper active region on the lower active region, the upper active region including a first upper gate electrode and a first upper active contact spaced apart from the first upper gate electrode, the first upper active contact vertically overlapping at least part of the first lower active contact;
a first connection structure that vertically connects the first upper active contact to the first lower active contact;
a first metal layer on the first surface; and
a backside metal layer on the second surface, wherein
the first upper gate electrode and the first lower gate electrode are connected and form a first gate electrode, and
the first metal layer includes a first node line that electrically connects the first gate electrode to the first upper active contact.

2. The device of claim 1, wherein
the lower active region further includes a second lower gate electrode and a second lower active contact spaced apart from the second lower gate electrode,
the upper active region further includes a second upper gate electrode and a second upper active contact spaced apart from the second upper gate electrode,
the second upper active contact vertically overlaps at least part of the second lower active contact,
the second upper active contact and the second lower active contact are vertically connected through a second connection structure,
the second upper gate electrode and the second lower gate electrode are connected and form a second gate electrode, and
the first metal layer further includes a second node line that electrically connects the second gate electrode to the second upper active contact.

3. The device of claim 2, wherein
the first node line corresponds to an output end of a first inverter of a static random access memory (SRAM) cell, and
the second node line corresponds to an output end of a second inverter of the SRAM cell.

4. The device of claim 2 or claim 3, wherein the first and second node lines have bar shapes which extend in parallel to each other.

5. The device of any preceding claim, wherein
the lower active region further includes a second lower active contact between the first lower gate electrode and the first lower active contact,
the upper active region further includes a second upper active contact between the first upper gate electrode and the first upper active contact,
the second upper active contact vertically overlaps at least part of the second lower active contact,
the backside metal layer includes a ground line and a power line,
the ground line is electrically connected to the second lower active contact, and
the power line is electrically connected to the second upper active contact.

6. The device of claim 5, further comprising:
a first lower via that electrically connects the ground line to the second lower active contact; and
a second lower via that electrically connects the power line to the second upper active contact, wherein
the second upper active contact includes a first portion that vertically overlaps at least part of the second lower active contact and at least part of a second portion other than the first portion, and
the second lower via is coupled to the second portion.

7. The device of claim 5 or claim 6, wherein the backside metal layer further includes a bit line.

8. The device of any preceding claim, wherein the first metal layer further includes a word line.

9. The device of any preceding claim, wherein
the lower active region includes a first semiconductor pattern and a second semiconductor pattern on the first semiconductor pattern,
the first lower gate electrode at least partly surrounds the first and second semiconductor patterns,
the upper active region includes a third semiconductor pattern and a fourth semiconductor pattern on the third semiconductor pattern, and
the first upper gate electrode at least partly surrounds the third and fourth semiconductor patterns.

10. The device of any preceding claim, wherein
the lower active region includes a first pull-down transistor and a second pull-down transistor,
the upper active region includes a first pull-up transistor and a second pull-up transistor,
the first lower active contact is connected to a source/drain of the first pull-down transistor,
the first upper active contact is connected to a source/drain of the first pull-up transistor,
the first lower gate electrode is connected to a gate of the second pull-down transistor, and
the first upper gate electrode is connected to a gate of the second pull-up transistor.
